(19) Europäisches Patentamt
European Patent Office
Office européen des brevets

(11) Veröffentlichungsnummer: **0 134 752 B1**

(12) **EUROPÄISCHE PATENTSCHRIFT**

(45) Veröffentlichungstag der Patentschrift: **27.01.88**

(51) Int. Cl.⁴: **G 03 F 7/10**, C 08 G 73/10, C 08 G 73/14, C 08 G 73/16

(21) Anmeldenummer: **84810231.5**

(22) Anmeldetag: **14.05.84**

(54) **Beschichtetes Material und seine Verwendung.**

(30) Priorität: **18.05.83 CH 2690/83**
**12.10.83 CH 5569/83**

(43) Veröffentlichungstag der Anmeldung:
**20.03.85 Patentblatt 85/12**

(45) Bekanntmachung des Hinweises auf die Patenterteilung:
**27.01.88 Patentblatt 88/4**

(84) Benannte Vertragsstaaten:
**BE CH DE FR GB IT LI NL SE**

(56) Entgegenhaltungen:
**DE - A - 3 007 445**
**FR - A - 2 456 339**
**FR - A - 2 496 111**
**US - A - 3 666 709**

(73) Patentinhaber: **CIBA-GEIGY AG, Klybeckstrasse 141, CH-4002 Basel (CH)**

(72) Erfinder: **Pfeifer, Josef, Dr., Brunnmattstrasse 32, CH-4106 Therwil (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 134 752 B1

ACTORUM AG

## Beschreibung

Die vorliegende Erfindung betrifft ein Verfahren zur Herstellung von Schutzschichten und Reliefstrukturen unter Verwendung eines mit einem strahlungsempfindlichen Polymer beschichteten Trägers, wobei das Polymer Benzophenontetracarbonsäureimideinheiten enthält, mit ausgewählten Polymeren beschichtete Träger, sowie die Verwendung dieses Materials für die photographische Erzeugung von Reliefstrukturen und von Schutzfilmen.

Photographische Abbildungsverfahren mit strahlungsempfindlichen Polymeren zur Erzeugung von Reliefabbildungen haben zur Herstellung von Bauteilen in der Elektronik und Halbleitertechnologie grosse Bedeutung erlangt. Von solchen Photopolymeren werden je nach Verwendungszweck bestimmte Eigenschaften verlangt und es sind hierfür verschiedenartige Polymere bekannt geworden. Die Lichtempfindlichkeit solcher Polymerer ist relativ gering, was den Zusatz von Photoinitiatoren oder Sensibilisatoren erfordert, um wirtschaftliche Belichtungszeiten zu erzielen. Nachteilig bei solchen Additiven ist, dass sie die mechanischen und physikalischen Eigenschaften vermindern können.

Für bestimmte Anwendungen sind ferner hohe Temperaturbeständigkeiten der erzeugten Strukturen oder photochemisch hergestellter Schutzüberzüge gewünscht. Besonders geeignet hierfür sind Polyimide. Wegen ihrer Unlöslichkeit muss man von löslichen Vorstufen ausgehen, die erst nach der Photopolymerisation durch eine thermische Nachbehandlung in Polyimide überführt werden. Eine direkte Photovernetzung von Polyimiden ist bisher nicht bekannt geworden.

Aus der DE-A-30 07 445 sind Polyamide und Polyester mit Benzophenontetracarbonsäureimideinheiten bekannt. Die physikalisch-mechanischen Eigenschaften von Fasern oder Filmen aus diesem Material können durch Belichtung verbessert werden. Von der Herstellung von Schutzüberzügen oder photographischen Abbildungsverfahren ist nichts erwähnt.

Gegenstand vorliegender Erfindung ist ein Verfahren zur Herstellung einer Reliefstruktur oder einer Schutzschicht auf einem Träger, auf den ein strahlungsempfindliches Homo- oder Copolymer als Schicht aufgebracht ist, wobei besagtes Homo- oder Copolymer mindestens 5 Mol.-%, bezogen auf das Polymer, Struktureinheiten der Formel I enthält

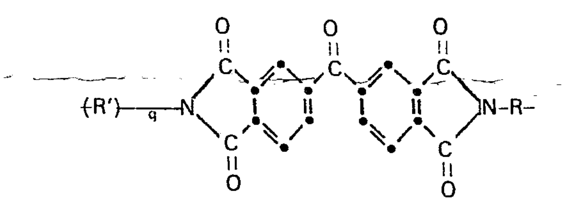

(I),

worin R ein zweiwertiger unsubstituierter oder substituierter aliphatischer Rest, der durch Heteroatome, aromatische, heterocyclische oder cycloaliphatische Gruppen unterbrochen sein kann, ein unsubstituierter oder substituierter, heterocyclischer, cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxyalkylgruppe, Alkoxygruppe, Alkylthiogruppe, Alkylthioalkylgruppe, Hydroxyalkylgruppe, Hydroxyalkoxygruppe, Hydroxyalkylthiogruppe, Aralkylgruppe oder zwei benachbarte C-Atome des aromatischen Restes durch eine Alkylengruppe substituierter aromatischer Rest ist, R' unabhängig die gleiche Bedeutung wie R hat und q für 0 oder 1 steht, wobei R als aromatischer Rest nicht durch Alkylen oder nicht in beiden Orthostellungen zum N-Atom durch die zuvor genannten Reste substituiert ist, wenn q=0 ist, umfassend die Schritte

i) bildmässiges oder direktes Belichten mit energiereicher Strahlung und gegebenenfalls

ii) Entfernen der unbelichteten Anteile mit einem Entwickler.

Die Menge an Strukturelementen der Formel I richtet sich im wesentlichen nach der gewünschten Lichtempfindlichkeit der Homo- oder Copolymeren und nach deren Aufbau. Die Menge kann 5 bis 100 Mol.-%, vorzugsweise 20 bis 100 Mol.-%, besonders 40 bis 100 Mol.-% und insbesondere 50 bis 100 Mol.-% betragen, bezogen auf das Polymer. Ganz besonders bevorzugt sind Homo- und Copolymere mit 80–100 Mol.-% Strukturelementen der Formel I.

Bei Homo- oder Copolymeren mit Strukturelementen der Formel I, worin R und R' einen aliphatischen oder cycloaliphatischen Rest bedeuten, beträgt die Menge dieser Strukturelemente bevorzugt mindestens 50 Mol.-%, besonders wenn es sich bei den Homo- und Copolymeren um Polyamide und Polyester handelt.

R bzw. R' in Formel I in der Bedeutung als zweiwertiger aliphatischer Rest enthält bevorzugt 2 bis 30, besonders 6 bis 30 und insbesondere 6 bis 20 C-Atome. In einer bevorzugten Untergruppe ist R bzw. R' lineares oder verzweigtes Alkylen, das durch Sauerstoffatome, S, SO, $SO_2$, NH, $NR^a$, $^{\oplus}NR^a{}_2G^{\ominus}$, Cyclohexylen, Naphthylen, Phenylen oder Hydantoinreste unterbrochen sein kann. $R^a$ kann z.B. Alkyl mit 1 bis 12 C-Atomen oder Cycloalkyl mit 5 oder 6 Ring-C-Atomen, Phenyl oder Benzyl sein. $G^{\ominus}$ bedeutet ein Anion einer Protonensäure, z.B. Halogenid, Sulfat, Phosphat. In einer bevorzugten Ausführungsform sind R bzw. R' lineares oder verzweigtes Alkylen mit 6 bis 30 C-Atomen, $-(CH_2)_m-R^1-(CH_2)_n-$, worin $R^1$ Phenylen, Naphthylen, Cyclopentylen oder Cyclohexylen und m und n unabhängig voneinander die Zahl 1, 2 oder 3 sind, $-R^2\text{-}(OR^3)_p\text{-}O-R^2-$, worin $R^2$ Äthylen, 1,2-Propylen, 1,3-Propylen oder 2-Methyl-1,3-propylen und $R^3$ Äthylen, 1,2-Propylen, 1,2-Butylen, 1,3-Propylen oder 1,4-Butylen und p eine Zahl von 1 bis 100 sind, oder

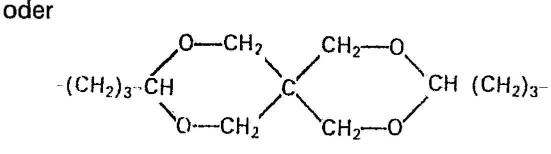

Beispiele für aliphatische Reste sind: Methylen, Äthylen, 1,2- oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1- bis 6 C-Atome aufweist, substituierte 1,11-Undecylene, wie sie z.B. in der EP-B-0 011 559 beschrieben sind, Jeffamine wie z.B.

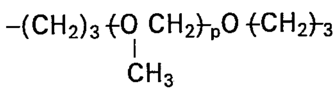 mit p=1 bis 100

oder $-(CH_2)_3-(O(CH_2)_4)_p-O-(CH_2)_3$ mit p=1–100, Dimethylencyclohexan, Xylylen und Diäthylenbenzol. Besonders bevorzugt sind R bzw. R' längerkettiges, verzweigtes Alkylen mit z.B. 8 bis 30 C-Atomen.

R bzw. R' in Formel I kann als aliphatischer Rest auch einen Polysiloxanrest der Formel

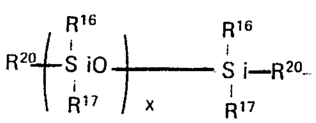

bedeuten, worin $R^{16}$ und $R^{17}$ $C_1$–$C_6$-Alkyl, besonders Methyl, oder Phenyl sind, $R^{20}$ Cycloalkylen wie z.B. Cyclohexylen und besonders $C_1$–$C_{12}$, insbesondere $C_1$–$C_6$-Alkylen, z.B. 1,3-Propylen oder 1,4-Butylen, ist und x für eine rationale Zahl von mindestens 1, z.B. 1 bis 100, bevorzugt 1 bis 10 steht. Solche Diamine mit diesem Rest sind in der US-A-3 435 002 und US-A-4 030 948 beschrieben.

Bei den durch heterocyclische Reste unterbrochenen aliphatischen Resten kann es sich z.B. um solche handeln, die sich von N,N'-aminoalkylierten Hydantoinen oder Benzimidazolen ableiten. Beispiele sind N,N'-(γ-Aminopropyl)-5,5-dimethyl-hydantoin oder -benzimidazolon und solche der Formel

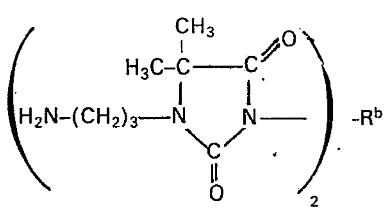

worin $R^b$ Alkylen mit 1 bis 12, bevorzugt 1 bis 4 C-Atomen oder $-(CH_2\underset{R^c}{\underset{|}{C}}HO)_aCH_2CH_2$ ist, worin $R^c$ ein Wasserstoffatom oder Methyl und a ganze Zahlen von 1–20 bedeuten.

Geeignete Substituenten für die aliphatischen Reste sind z.B. Hydroxyl, Halogenid wie F oder Cl oder Alkoxy mit 1 bis 6 C-Atomen.

Heterocyclische Diaminreste leiten sich bevorzugt von N-heterocyclischen Diaminen ab, z.B. von Pyrrolidin, Indol, Piperidin, Pyridin, Pyrrol, deren N-Atom alkyliert, z.B. methyliert, sein kann. Ein Beispiel ist N-Methyl-4-amino-5-aminomethylpiperidin.

R bzw. R' in Formel I in ihrer Bedeutung als zweiwertiger cycloaliphatischer Rest enthält bevorzugt 5 bis 8 Ring-C-Atome und sind besonders unsubstituiertes oder mit Alkyl, das vorzugsweise 1 bis 4 C-Atome enthält, substituiertes ein- oder zweikerniges Cycloalkylen mit 5 bis 7 Ring-C-Atomen. In einer bevorzugten Ausführungsform sind R bzw. R' als cycloaliphatischer Rest solche der Formeln

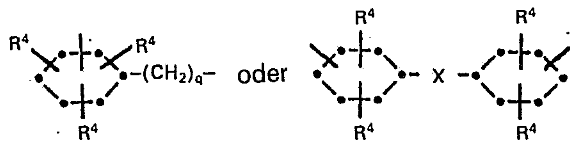

worin q 0 oder 1 ist, die $R^4$ unabhängig Wasserstoff oder Alkyl mit 1 bis 6 C-Atomen bedeuten und X für eine direkte Bindung, O, S, $SO_2$, Alkylen mit 1 bis 3 C-Atomen oder Alkyliden mit 2 bis 6 C-Atomen steht. $R^4$ ist bevorzugt Äthyl und Methyl, X bevorzugt Methylen und das Alkyliden enthält bevorzugt 2 oder 3 C-Atome, wie Äthyliden und 1,1- oder 2,2-Propyliden.

Beispiele für R bzw. R' als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 3- oder 4-Methylcyclohex-1-yl, 5-Methyl- 3-methylencyclohex-1-yl, 3,3'- oder 4,4'-Bis-cyclohexylen, 3,3'-Dimethyl-4,4'-biscyclohexylen, 4,4'-Biscyclohexylenäther oder -sulfon oder -methan oder -2,2-propan, sowie die Reste von Bis-aminomethyltricyclodecan, Bis-aminomethylnorbornan und Menthandiamin.

Besonders bevorzugt sind R bzw. R' als cycloaliphatischer Rest 1,4- oder 1,3-Cyclohexylen, 2,2,6-Trimethyl-6-methylen-cyclohex-4-yl, Methylenbis(cyclohex-4-yl) oder Methylenbis(3-methylcyclohex-4-yl).

R bzw. R' als araliphatischer Rest enthalten bevorzugt 7 bis 30 C-Atome. Sofern die aromatische Gruppe des araliphatischen Restes an die N-Atome im Rest der Formel I gebunden sind, was bevorzugt ist, so sind diese aromatischen Gruppen bevorzugt so substituiert wie R bzw. R' als aromatischer Rest, einschliesslich der Bevorzugungen.

Der araliphatische Rest enthält bevorzugt 7 bis 30, besonders 8 bis 22 C-Atome. Der aromatische Rest im araliphatischen Rest ist bevorzugt ein Phenylrest. In ihrer Bedeutung als araliphatischer Rest bedeuten R bzw. R' besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

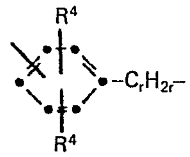

worin die $R^4$ unabhängig voneinander ein Wasserstoffatom oder besonders Alkyl mit 1–6 C-Atomen und r ganze Zahlen von 1–20 bedeuten.

Die freie Bindung kann sich in o-Stellung, m-Stellung und besonders in p-Stellung zur $C_rH_{2r}$-Gruppe befinden und eine oder beide $R^4$ sind bevorzugt in o-Stellung zur freien Bindung gebunden.

Beispiele für R bzw. R' als araliphatischer Rest sind: m- oder p-Benzylen, 3-Methyl-p-benzylen, 3-Äthyl-p-Benzylen, 3,5-Dimethyl-p-benzylen, 3,5-Diäthyl-p-benzylen, 3-Methyl-5-äthyl-p-benzylen, p-Phenylenpropylen, 3-Methyl-p-phenylen-propylen, p-Phenylenbutylen, 3-Äthyl-p-phenylenpentylen sowie insbesondere längerkettige Phenylenalkylenreste, die z.B. in der EP-A-0 069 062 beschrieben sind: 6-(p-Phenylen)-6-methylhept-2-yl, 6-(3'-Methyl-p-phenylen)-6-methylhept-2-yl, 6-(3'-Äthyl-p-phenylen)-6-methylhept-2-yl, 6-(3', 5'-Dimethyl-p-phenylen)-6-methylhept-2-yl, 11-(p-Phenylen)-2,11-dimethyl-dodec-1-yl, 13-(p-Phenylen)-2,12-dimethyltetradec-3-yl.

R bzw. R' können auch ein aromatischer Rest sein, bei dem zwei Arylkerne, besonders Phenyl über eine aliphatische Gruppe verknüpft sind. Dieser Rest entspricht bevorzugt der Formel

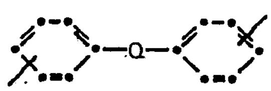

worin die freien Bindungen in p-, m- und besonders o-Stellung zur Q-Gruppe gebunden sind und Q $C_1$–$C_{12}$-, besonders $C_1$–$C_6$-Alkylen ist, das durch O oder S unterbrochen sein kann. Beispiele für Q sind Äthylen, 1,2- oder 1,3-Propylen, Butylen, $-CH_2-O-CH_2$, $-CH_2-S-CH_2-$ und $-CH_2CH_2-O-CH_2CH_2-$.

Unter den Homo- und Copolymeren sind besonders solche mit Strukturelementen der Formel I bevorzugt, in der R bzw. R' substituierte aromatische Reste bedeuten. Der Substituent am aromatischen Rest enthält bevorzugt 1 bis 20, besonders 1–12 und insbesondere 1–6 C-Atome. Insbesondere ist der Substituent $C_5$- oder $C_6$-Cycloalkyl, lineares oder verzweigtes Alkyl, Alkoxy, Alkoxyalkyl, Alkylthio, Alkylthioalkyl, Hydroxyalkyl, Hydroxyalkoxy oder Hydroxyalkylthio mit 1 bis 6 C-Atomen, Benzyl, Trimethylen oder Tetramethylen. Als Alkoxyalkyl ist Alkoxymethyl bevorzugt und als Alkoxy Methoxy. Beispiele für den Substituenten sind: Methyl, Äthyl, Propyl, Isopropyl, n-Butyl, Isobutyl, Pentyl, Hexyl, Octyl, Dodecyl, Tetradecyl, Eicosyl, Methoxy, Äthoxy, Propoxy, Butoxy, Pentoxy, Hexoxy, Methoxymethyl, Methoxyäthyl, Äthoxymethyl, Propoxymethyl, Butoxymethyl, Benzyl, Methylbenzyl, Phenyläthyl, Methylthio, Äthylthio, Hydroxyäthyl, Methylthioäthyl und Hydroxyäthylthio. Bevorzugte Reste sind Methoxymethyl, Äthoxymethyl, Methyl, Äthyl, n-Propyl, i-Propyl, Trimethylen und Tetramethylen, Cyclopentyl und Cyclohexyl. Besonders bevorzugt ist Methyl, Äthyl und i-Propyl. Bei dem substituierten aromatischen Rest kann es sich um einkernige oder mehrkernige, besonders zweikernige Reste handeln. Einkernige Reste können bis zu 4, bevorzugt 2, besonders 1 Substituenten enthalten und zweikernige Reste können bis zu 4, bevorzugt 1 oder 2 Substituenten in jedem Kern enthalten. Es wurde gefunden, dass die Lichtempfindlichkeit von Homo- oder Copolymeren besonder hoch ist, wenn ein oder zwei Substituenten in Orthostellung zum N-Atom gebunden sind. Die Substitution in Orthostellung ist daher bevorzugt. Der aromatische Rest ist bevorzugt in Meta- oder Parastellung zum N-Atom gebunden.

R bzw. R' kann als aromatischer Rest 7 bis 30, besonders 7 bis 20 C-Atome enthalten. Der aromatische Rest ist bevorzugt ein Kohlenwasserstoffrest oder Pyridinrest, der wie zuvor definiert substituiert ist.

Eine bevorzugte Untergruppe sind solche aromatische Reste der Formeln

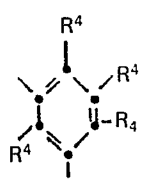
,
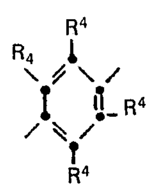
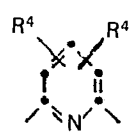
,

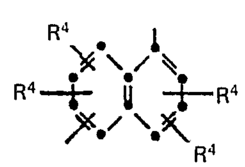
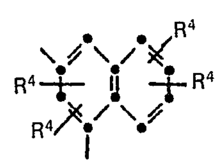
,
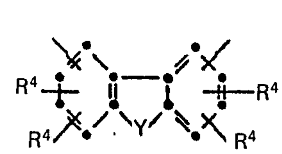

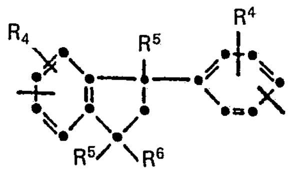

oder

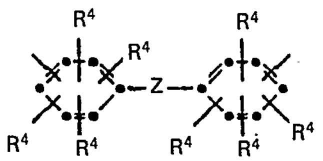

worin $R^4$ im Falle der Monosubstitution Alkyl mit 1 bis 6 C-Atomen und die anderen $R^4$ Wasserstoff sind, und im Falle der Di-, Tri- oder Tetrasubstitution zwei $R^4$ Alkyl mit 1 bis 6 C-Atomen und die anderen $R^4$ ein Wasserstoffatom oder Alkyl mit 1 bis 6 C-Atomen sind oder im Falle der Di-, Tri- oder Tetrasubstitution zwei vicinale $R^4$ im Phenylring für Trimethylen oder Tetramethylen und die anderen $R^4$ für ein Wasserstoffatom oder Alkyl mit 1 bis 6 C-Atomen stehen, Y für O, S, NH, CO oder $CH_2$ steht, $R^5$ ein Wasserstoffatom oder Alkyl mit 1 bis 5 C-Atomen und $R^6$ Alkyl mit 1 bis 5 C-Atomen darstellt, und Z eine direkte Bindung, O, S, SO, $SO_2$, CO,

$\overset{O}{\overset{\|}{C}}O$, $\overset{O}{\overset{\|}{C}}NR^7$, $NR^7$, CONH, NH, $R^7SiR^8$, $R^7OSiOR^8$,

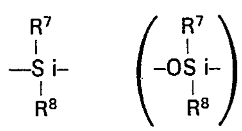

Alkylen mit 1 bis 6 C-Atomen, das durch –O– oder –S– unterbrochen sein kann, Alkenylen oder Alkyliden mit 2 bis 6 C-Atomen, Phenylen oder Phenyldioxyl bedeutet, worin $R^7$ und $R^8$ unabhängig voneinander Alkyl mit 1 bis 6 C-Atomen oder Phenyl bedeuten und j für 1–10, besonders 1–3 steht. Z kann weiter der Formel

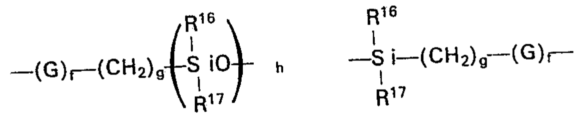

entsprechen worin G für S und besonders für O steht, f=0 oder besonders 1, g=1–6 und h=1 bis 50, besonders 1 bis 10 bedeuten, und $R^{16}$ und $R^{17}$ die zuvor angegebene Bedeutung haben, sowie einen Rest der Formel

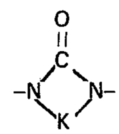

entsprechen worin K für $-\overset{O}{\overset{\|}{C}}-\overset{O}{\overset{\|}{C}}-$, $-\overset{R^{25}}{\overset{|}{C}}R^{25}\overset{O}{\overset{\|}{C}}-$ oder $-\overset{O}{\overset{\|}{C}}-\overset{R^{25}}{\overset{|}{N}}-\overset{O}{\overset{\|}{C}}$ mit $R^{25}$ gleich H, $C_1$–$C_6$-Alkyl oder Phenyl steht. $R^5$ und $R^6$ sind bevorzugt Methyl, Y steht bevorzugt für $-CH_2-$ oder –O– und Z bevorzugt für eine direkte Bindung, –O–, $-CH_2-$ oder Alkyliden mit 2 bis 4 C-Atomen. $R^7$ und $R^8$ stehen besonders für Methyl, Äthyl und Phenyl. Das Alkylen enthält bevorzugt 2 bis 4 C-Atome und ist besonders Äthylen. Alkenylen ist besonders Äthenylen.

Eine bevorzugte Untergruppe sind Toluylenreste, Reste O,O'-substituierter Diaminodiphenylene, Diaminodiphenylmethane und Diaminodiphenyläther.

Eine besonders bevorzugte Gruppe sind solche aromatische Reste der Formeln

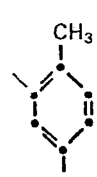 , 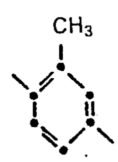 , 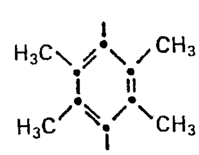 , 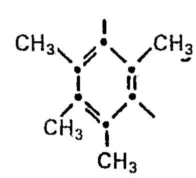

oder 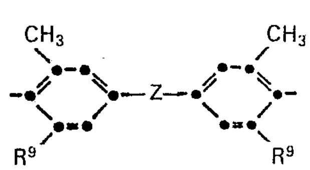

worin Z eine direkte Bindung, O und besonders $CH_2$ bedeutet und $R^9$ ein Wasserstoffatom, Methyl, Äthyl oder Isopropyl darstellt.

Beispiele für substituierte aromatische Reste sind: 4-Methyl-1,3-phenylen, 4-Äthyl-1,3-phenylen, 2-Methyl-1,3-phenylen, 4-Benzyl-1,3-phenylen, 4-Methoxymethyl-1,3-phenylen, Tetrahydro-1,3- oder -1,4-naphthylen, 3-Propyl-1,3- oder -1,4-phenylen, 3-Isopropyl-1,4-phenylen, 3,5-Dimethyl-1,4-phenylen, 2,4-Dimethyl-1,3-phenylen, 2,3-Dimethyl-1,4-phenylen, 5-Methyl-1,3-phenylen, 2,3,5,6-Tetramethyl-1,4- oder -1,3-phenylen, 3-Methyl-2,6-pyridylen, 3,5-Dimethyl-2,6-pyridylen, 3-Äthyl-2,6-pyridylen, 1-Methyl-2,7-naphthylen, 1,6-Dimethyl-2,7-naphthylen, 1-Methyl-2,4-naphthylen, 1,3-Dimethyl-2,4-naphthylen, die zweiwertigen Reste von 5-Amino-1-(3'-amino-4'-methylphenyl)-1,3,3-trimethylindan oder 6-Amino-5-methyl-1-(3'-amino-4'-methyl)-1,3,3-trimethylindan, 4-Methoxymethyl-1,3-phenylen, 3-Methyl p-diphenylen, 3-Äthyl-p-diphenylen, 3,3-Dimethyl-p-diphenylen, 3,3'-Diäthyl-p-diphenylen,3-Methyl-3'-äthyl-p-diphenylen,3,3',5,5'-Tetramethyl-diphenylen, 3,3'-Methyl-5,5'-äthyl-p-diphenylen, 4,4'-Dimethyl-m-diphenylen, 3,3'-Diisopropyldiphenylen,Reste der Formeln

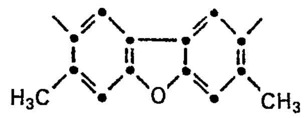 ,

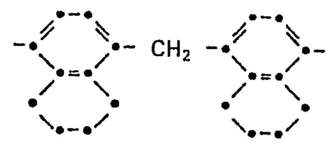 ,

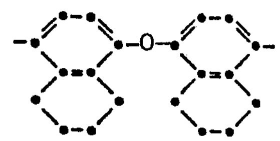 ,

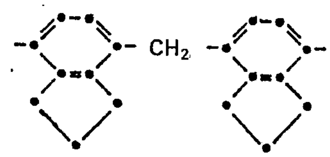 ,

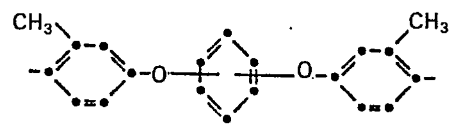

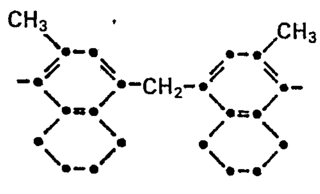 ,

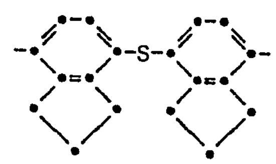 ,

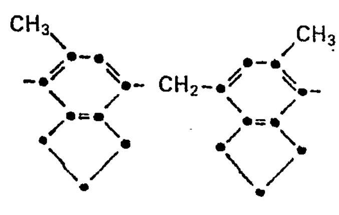 ,

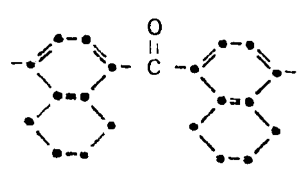 ,

sowie

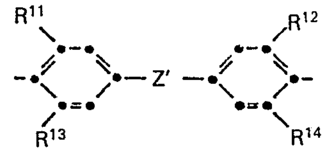 ,

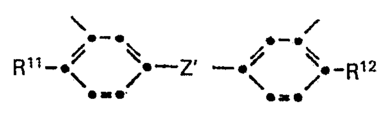

und 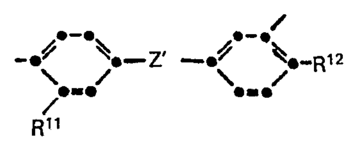

worin Z; $R^{11}$, $R^{12}$, $R^{13}$ und $R^{14}$ die in nachfolgender Tabelle angegebenen Bedeutungen haben:

| Z' | $R^{11}$ | $R^{12}$ | $R^{13}$ | $R^{14}$ |
|---|---|---|---|---|
| $CH_2$ | Methyl | Methyl | – | – |
| $CH_2$ | Methyl | Äthyl | – | – |
| $CH_2$ | Äthyl | Äthyl | – | – |
| $CH_2$ | Isopropyl | Isopropyl | – | – |
| $CH_2$ | Methoxymethyl | | – | – |
| $CH_2$ | Benzyl | Benzyl | – | – |
| $CH_2$ | Methyl | Methyl | H | H |
| $CH_2$ | Äthyl | Äthyl | H | H |
| $CH_2$ | Isopropyl | Isopropyl | H | H |
| $CH_2$ | Methoxymethyl | | H | H |
| $CH_2$ | Methyl | Äthyl | H | H |
| $CH_2$ | Methoxymethyl | | Methoxymethyl | |
| $CH_2$ | Methyl | Methyl | Methyl | Methyl |
| $CH_2$ | Äthyl | Äthyl | Äthyl | Äthyl |
| $CH_2$ | Methyl | Methyl | Äthyl | Äthyl |
| $CH_2$ | Äthyl | Äthyl | Isopropyl | Isopropyl |
| $CH_2$ | Isopropyl | Isopropyl | Isopropyl | Isopropyl |
| $CH_2$ | Isopropyl | Isopropyl | H | H |
| $CH_2$ | Methoxy | Methoxy | H | H |
| O | Methyl | Methyl | – | – |
| O | Äthyl | Äthyl | – | – |
| O | Methyl | Methyl | H | H |
| O | Methyl | Methyl | Methyl | Methyl |
| O | Methyl | Methyl | Äthyl | Äthyl |
| S | Methyl | Methyl | – | – |
| S | Äthyl | Äthyl | – | – |
| S | Methyl | Methyl | H | H |
| S | Methyl | Methyl | Methyl | Methyl |
| S | Äthyl | Äthyl | Äthyl | Äthyl |
| S | Methyl | Methyl | Äthyl | Äthyl |
| CO | Methyl | Methyl | – | – |
| CO | Methyl | Methyl | H | H |
| CO | Methyl | Methyl | Methyl | Methyl |
| $SO_2$ | Methyl | Methyl | – | – |
| $SO_2$ | Methyl | Methyl | H | H |
| $SO_2$ | Methyl | Methyl | Methyl | Methyl |
| $SO_2$ | Äthyl | Äthyl | Methyl | Methyl |
| SO | Methyl | Methyl | – | – |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | – | – |
| $NCH_3$ | Methyl | Methyl | Methyl | Methyl |
| CONH | Methyl | Methyl | – | – |
| NH | Äthyl | Äthyl | H | H |
| NH | Methyl | Methyl | – | – |
| $Si(Methyl)_2$ | Methyl | Methyl | – | – |
| $Si(Phenyl)_2$ | Methyl | Methyl | Methyl | Methyl |
| $Si(OMethyl)_2$ | Äthyl | Äthyl | – | – |
| $Si(OPhenyl)_2$ | Methyl | Methyl | H | H |
| Äthylen | Methyl | Methyl | – | – |
| Äthylen | Methyl | Methyl | Methyl | Methyl |
| Äthylen | Äthyl | Äthyl | H | H |
| Äthylen | Methyl | Methyl | – | – |
| Phenylen | H | H | Methyl | Methyl |
| Phenylen | Alkyl | Alkyl | – | – |
| $(CH_3)_2C<$ | Methyl | Methyl | H | H |
| $(CH_3)_2C<$ | Methyl | Methyl | Methyl | Methyl |
| $(CF_3)_2C<$ | Methyl | Methyl | Methyl | Methyl |

Die Diamine, von denen sich R bzw. R' ableiten, sind bekannt oder können nach bekannten Verfahren hergestellt werden. Diamine mit Polysiloxaneinheiten sind aus der US-A-3 435 002 bekannt und aus der EP-A-0 054 426.

Die erfindungsgemäss zu verwendenden Polymeren weisen mittlere Molekulargewichte (Zahlenmittel) von mindestens 2000, vorzugsweise mindestens 5000 auf. Die obere Grenze richtet sich im wesentlichen nach Eigenschaften, die die Verarbeitbarkeit bestimmen, wie z.B. deren Löslichkeit. Sie kann bis zu 500 000, vorzugsweise bis zu 100 000 und besonders bis zu 60 000 betragen. Es kann sich ferner um statistische Polymere oder um Blockpolymere handeln. Sie werden nach üblichen Verfahren in hierfür vorgesehenen Einrichtungen hergestellt. Die Polymeren sind vorzugsweise linear aufgebaut, können aber mit mindestens trifunktionellen Monomeren, die in kleinen Mengen zugesetzt werden, wenig verzweigt sein.

Die Homo- oder Copolymeren sind bevorzugt ausgewählt aus der Gruppe der Polyimide, Polyamide, gesättigte Polyester, Polycarbonate, Polyamidimide, Polyesterimide, Polyesteramide, Polysiloxane, ungesättigten Polyester, Epoxidharze, der aromatischen Polyäther, der aromatischen Polyätherketone, der aromatischen Polyäthersulfone, der aromatischen Polyketone, der aromatischen Polythioäther, der aromatischen Polyimidazole, der aromatischen Polypyrrone oder Gemischen dieser Polymeren.

Materialien enthaltend strahlungsempfindliche Schichten aus diesen Polymeren sind, mit Ausnahme der Polyimide, neu und ebenfalls Gegenstand der vorliegenden Erfindung.

Beschichtete Materialien enthaltend Polyimidschichten auf Basis von Benzophenontetracarbonsäure sind aus der US-A-3 666 709 bekannt. Eine Photovernetzung dieser Schichten wird dort nicht vorgeschlagen.

Ganz besonders bevorzugt im Verfahren dieser Erfindung sind unter diesen Polymeren Polyimide mit wiederkehrenden Strukturelementen der Formel I, wobei q=0 ist, oder Copolyimide aus wiederkehrenden Strukturelementen der Formel I, worin q=0 ist, und wiederkehrenden Strukturelementen der Formel II

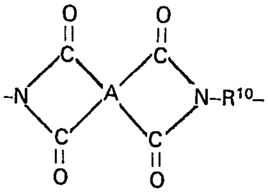 (II)

worin A ein vierwertiger organischer Rest und $R^{10}$ ein zweiwertiger organischer Rest sind.

R und $R^{10}$ stellen in den Homo- und Copolyimiden besonders aromatische organische Reste dar. Von den Copolyimiden sind besonders solche bevorzugt, die mindestens 60 Mol.-%, vorzugsweise 80 Mol.-% Strukturelemente der Formel I enthalten.

A in Formel II kann als Nichtbenzophenonrest aus den folgenden Gruppen ausgewählt sein: aromatische, aliphatische, cycloaliphatische, heterocyclische Gruppen, Kombinationen von aromatischen und aliphatischen Gruppen. Die Gruppen können auch substituiert sein. Die Gruppen A können durch die folgenden Strukturen gekennzeichnet sein:

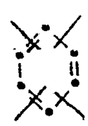 , 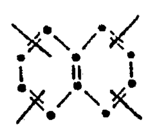 , 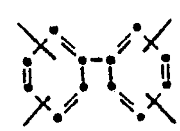

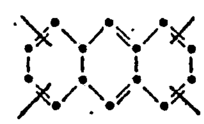 , 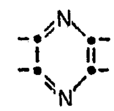 , 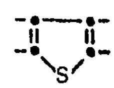

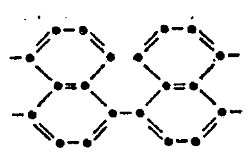 , 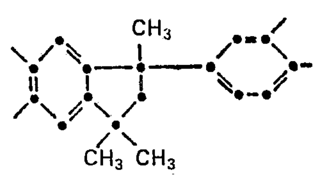

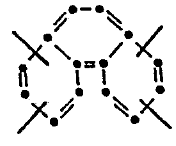 , 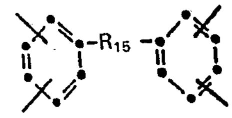

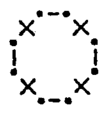 , 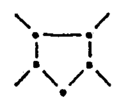 und 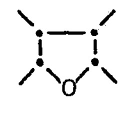

worin $R_{15}$ ausgewählt wird aus der Gruppe, bestehend aus

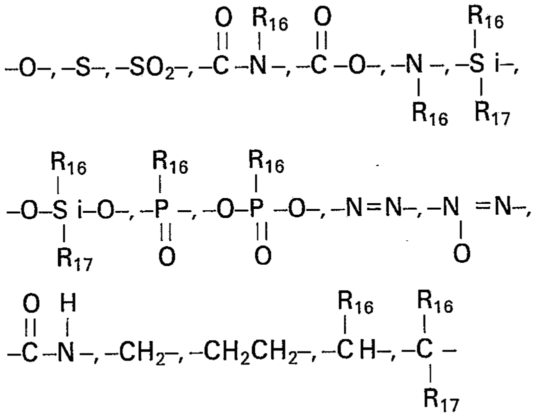

Phenylen und $-O-(R^d-O)_b-$, worin b 1–10 und $R^d$ Alkylen, Cycloalkylen, Arylen oder Aralkylen bedeuten, wobei $R_{16}$ und $R_{17}$ Alkyl mit bevorzugt 1 bis 6 C-Atomen oder Aryl, besonders Phenyl, bedeuten. Von den freien Bindungen in den voranstehenden Formeln befinden sich stets zwei an vicinalen C-Atomen.

Geeignete Tetracarbonsäureanhydride oder deren Ester mit einem vierwertigen Rest A sind z.B.:
2,3,9,10-Perylentetracarbonsäuredianhydrid,
1,4,5,8-Naphthalintetracarbonsäuredianhydrid,
2,6-Dichlornaphthalin-1,4,5,8-tetracarbonsäuredianhydrid,
2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
Pyromellitsäuredianhydrid,
3,3', 4,4'-Biphenyltetracarbonsäuredianhydrid,
2,2', 3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
4,4'–Sulfonyldiphthalsäureanhydrid,
3,3'-Oxydiphthalsäureanhydrid,
4,4'-Methylendiphthalsäureanhydrid,
4,4'-Thiodiphthalsäureanhydrid,
4,4'-Äthylidendiphthalsäureanhydrid,
2,3,6,7-Naphthalintetracarbonsäuredianhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Thiophen-2,3,4,5-tetracarbonsäuredianhydrid,
1-(3', 4'-Dicarboxyphenyl)-1,3,3-trimethylindan-5,6-dicarbonsäuredianhydrid,
1-(3', 4'-Dicarboxyphenyl)-1,3,3-trimethylindan-6,7-dicarbonsäuredianhydrid,
1-(3', 4'-Dicarboxyphenyl)-3-methylindan-5,6-dicarbonsäuredianhydrid,
Tetrahydrofurantetracarbonsäuredianhydrid,
Cyclopentantetracarbonsäuredianhydrid,
Cyclooctantetracarbonsäuredianhydrid und
1,(3',4'-Dicarboxyphenyl)-3-methylindan-6,7-dicarbonsäuredianhydrid und Dianhydride der allgemeinen Formel

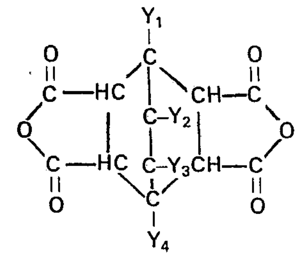

worin $Y_1$, $Y_2$, $Y_3$ und $Y_4$ jeweils unter Wasserstoff, Alkyl, besonders Methyl ausgewählt werden.

Die bevorzugtesten Nicht-Benzophenon-aromatischen Dianhydride sind Pyromellitsäuredianhydrid und aromatische Dianhydride, gekennzeichnet durch die allgemeine Formel

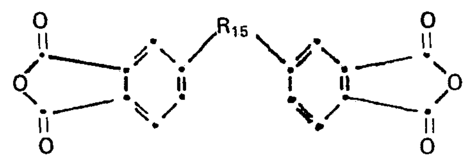

worin $R_{15}$ Methylen, Sauerstoff, Sulfonyl oder

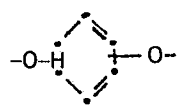 bzw. 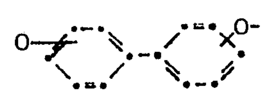

bedeutet.

Die vorstehend definierte Gruppe $R^{10}$ kann ausgewählt werden unter Alkylengruppen mit 2 bis 20 Kohlenstoffatomen, Cycloalkylengruppen mit 4 bis 6 Ringkohlenstoffatomen; einer Xylylengruppe, Arylengruppe ausgewählt unter meta- oder para-Phenylen, Tolylen, Byphenylen, Naphthylen oder Anthrylen; einer unsubstituierten oder substituierten Arylengruppe der Formel

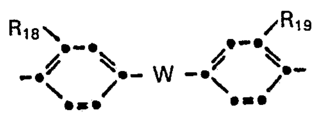

worin W eine covalente Bindung, Schwefel, Carbonyl, –NH, –N-Alkyl, O, S, SS, –N-Phenyl, Sulfonyl, eine lineare oder verzweigte Alkylengruppe mit 1 bis 3 Kohlenstoffatomen, Alkyliden mit 2 bis 12 C-Atomen, Cycloalkyliden mit 5 oder 6 Ringkohlenstoffatomen, Arylen, insbesondere die Phenylengruppe, oder eine Dialkyl- oder Diarylsilylgruppe bedeutet und $R_{18}$ und $R_{19}$ unabhängig voneinander jeweils Wasserstoff, Halogen, insbesondere Chlor oder Brom, Alkyl mit 1 bis 5 Kohlenstoffatomen, insbesondere Methyl, Alkoxy mit 1 bis 5 Kohlenstoffatomen, insbesondere Methoxy, oder Aryl, insbesondere Phenyl, bedeuten.

Bevorzugter umfasst $R^{10}$ Gruppen, die von den aromatischen Diaminen abgeleitet werden, die zuvor beschrieben wurden. Am bevorzugtesten stellt $R^{10}$ eine Gruppe der Formel

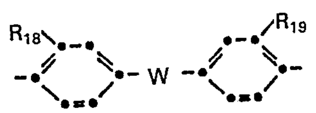

dar, worin W eine covalente Bindung, Methylen, Schwefel, Sauerstoff oder Sulfon darstellt und $R_{18}$ und $R_{19}$ unabhängig voneinander Wasserstoff, Halogen oder Alkyl mit 1 bis 5 Kohlenstoffatomen, insbesondere Methyl, bedeuten, oder eine Gruppe der Formel

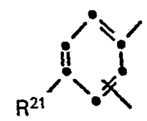

worin $R^{21}$ Wasserstoff, Halogen oder Alkyl mit 1 bis 5 Kohlenstoffatomen, insbesondere Methyl, bedeutet.

Besonders bevorzugt ist $R^{10}$ meta- oder para-Phenylen oder ein Rest der Formel

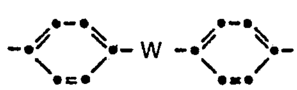

worin W eine kovalente Bindung, Methylen, 2,2-Propyliden, Cyclohexyliden, Schwefel, Sauerstoff oder Sulfon bedeutet.

Beispiele für Diamine mit einem zweiwertigen Rest $R^{10}$ sind:

4,4'-Methylenbis-(o-chloranilin), 3,3'-Dichlorbenzidin, 3,3'-Sulfonyldianilin, 4,4'-Diaminobenzophenon, 1,5-Diaminonaphthalin, Bis-(4-aminophenyl)-dimethylsilan, Bis-(4-aminophenyl)-diäthylsilan, Bis-(4-aminophenyl)-diphenylsilan, Bis-(4-aminophenyloxy)-dimethylsilan, Bis-(4-aminophenyl)-äthylphosphinoxid, N-[Bis-(4-aminophenyl)]-N-methylamin, N-[Bis-(4-aminophenyl)]-N-phenylamin, 4,4'-Methylenbis-(3-methylanilin), 4,4'-Methylenbis-(2-äthylanilin), 4,4'-Methylenbis-(2-methoxyanilin), 5,5'-Methylenbis-(2-aminophenol), 4,4'-Methylenbis-(2-methylanilin), 4,4'-Oxybis-(2-methoxyanilin), 4,4'-Oxybis-)2-chloranilin), 5,5'-Oxybis-(2-aminophenol), 4,4'-Thiobis-(2-methylanilin), 4,4'-Thiobis- (2-methoxyanilin), 4,4'-Thiobis- (2-chloranilin), 4,4'-Sulfonylbis-(2-methylanilin), 4,4'-Sulfonylbis-(2-äthoxyanilin), 4,4'-Sulfonylbis-(2-chloranilin), 5,5'-Sulfonylbis-(2-aminophenol), 3,3'-Dimethyl-4,4'-diaminobenzophenon, 3,3'Dimethoxy-4,4'-diaminobenzophenon, 3,3'-Dichlor-4,4'-diaminobenzophenon, 4,4'-Diaminobiphenyl, m-Phenylendiamin, p-Phenylendiamin, 4,4'-Methylendianilin, 4,4'-Oxydianilin, 4,4'-Thiodianilin, 4,4'Sulfonyldianilin, 4,4'-Isopropylidendianilin, 3,3'-Dimethylbenzidin, 3,3'-Dimethoxybenzidin, 3,3'-Dicarboxybenzidin, Diaminotoluol, 4,4'-Methylen- bis-(3- carboxyanilin) und deren Ester.

Die Herstellung der Homo- und Copolyimide erfolgt in üblicher Weise durch Umsetzung von Benzophenontetracarbonsäureanhydrid mit Diaminen der Formel $NH_2RNH_2$, gegebenenfalls zusammen mit weiteren Tetracarbonsäureanhydriden der Formel

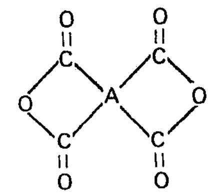

und/oder weiteren Diaminen der Formel $NH_2R^{10}NH_2$, und anschliessende Imidcyclisierung unter Einwirkung von Carbonsäureanhydriden und/oder anschliessendes Erhitzen. Bei einem weiteren bekannten Verfahren werden Diisocyanate mit Tetracarbonsäuredianhydriden zu Polyimiden umgesetzt.

Zur Herstellung der anderen ausgewählten Homo- und Copolymeren geht man von funktionellen Imidderivaten der Benzophenontetracarbonsäure aus. Sie können der Formel III entsprechen,

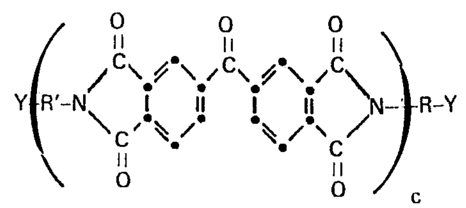 (III)

worin R und R' die zuvor angegebene Bedeutung haben, c eine Zahl von 1 bis etwa 500 und Y eine funktionelle Gruppe sind. Solche funktionelle Gruppen können z.B. sein:

$NHR^{22}$, OH, SH, O–Acyl, $COOR^{22}$, $CON(R^{22})_2$, COCl, COBr,

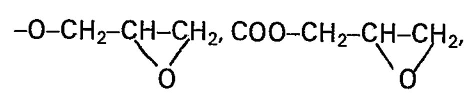

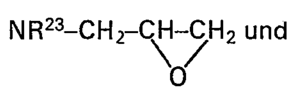 und Halogen, besonders Cl und Br. $R^{22}$ steht für ein Wasserstoffatom oder einen gegebenenfalls hydroxylierten Kohlenwasserstoffrest, z.B. Alkyl oder Hydroxyalkyl mit vorzugsweise 1–20, besonders 1–12 C-Atomen, Aralkyl mit vorzugsweise 7–20, besonders 7–16 C-Atomen, Aryl mit vorzugsweise 6–20, besonders 6–16 C-Atomen oder Cycloalkyl mit vorzugsweise 5–7 Ring-C-Atomen. $R^{23}$ kann die gleiche Bedeutung wie $R^{22}$ haben oder

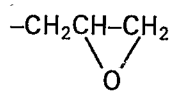 bedeuten. Die Acylgruppe kann 1

bis 20, bevorzugt 1–12 C-Atome enthalten.

Die Verbindungen der Formel III, worin c=1 ist, sind teilweise aus der DE-A-30 07 445 bekannt oder können nach analogen Verfahren hergestellt werden. Die Einführung weiterer funktioneller Gruppen wie z.B. der Glycidylgruppe erfolgt nach üblichen Verfahren.

Die Verbindungen der Formel III mit c>1 sind neu. Es handelt sich um oligomere und niedermolekulare Polyimide mit funktionellen Endgruppen. Sie werden nach analogen Verfahren erhalten wie Polyimide, wobei die Grösse von c durch die Menge an miteingesetzten Monomeren der Formel Y–R–$NH_2$ bestimmt wird. Mit diesen Oligomeren und niedermolekularen Polymeren werden z.B. Blockpolymere mit Polyimidblöcken und z.B. Polyamid-, Polyester oder anderen Polyimidblöcken erhalten.

Eine weitere bevorzugte Gruppe an Polymeren für das erfindungsgemässe Material ist ein Polyamid oder Copolyamid aus organischen Diaminen, Dicarbonsäuren, ω-Aminocarbonsäuren und Diaminen oder Dicarbonsäuren mit Strukturelementen der Formel I, worin q=1 ist und in denen an die R- und R′-Gruppen Amingruppen oder Carboxylgruppen gebunden sind, sowie aus Mischungen der Monomeren.

Bei den Homopolymeren kann es sich um solche handeln, deren Molekülketten aus Dicarbonsäuren und Diaminen mit Strukturelementen der Formel I aufgebaut sind, oder um solche, deren Molekülketten aus Dicarbonsäuren bzw. Diaminen mit Strukturelementen der Formel I und organischen Diaminen bzw. Dicarbonsäuren aufgebaut sind, die keine Benzophenonreste enthalten. Die Copolyamide enthalten weitere Diamine- bzw. Dicarbonsäurereste bzw. Aminocarbonsäurereste.

Geeignete Dicarbonsäuren sind z.B. lineare oder verzweigte aliphatische Dicarbonsäuren mit bevorzugt 2 bis 20, besonders 4 bis 16 C-Atomen, unsubstituierte oder durch besonders Alkyl substituierte cycloaliphatische Dicarbonsäuren mit 5 bis 7 Ring-C-Atomen und unsubstituierte oder z.B. mit Alkyl, Cl oder Brom substituierten aromatischen Dicarbonsäuren mit bevorzugt 8 bis 22 C-Atomen. Beispiele sind: Malonsäure, Adipinsäure, Trimethyladipinsäure, Pimelinsäure, Korksäure, Azelainsäure, Dodecandicarbonsäure, Cyclohexandicarbonsäuren, Isophthalsäure, Terephthalsäure, p-Diphenyldicarbonsäure, Bis-(4-carboxylphenyl)äther oder Bis(4-carboxylphenyl-sulfon.

Geeignete Diamine sind z.B. lineare oder verzweigte aliphatische Diamine mit bevorzugt 2 bis 30, besonders 4 bis 20 C-Atomen, unsubstituierte oder durch Alkyl, besonders Methyl substituierte cycloaliphatische Diamine mit bevorzugt 5 bis 7 Ring-C-Atomen, araliphatische Diamine mit bevorzugt 7 bis 24 C-Atomen und aromatische Diamine mit 6 bis 22, vorzugsweise 6 bis 18 C-Atomen, die unsubstituiert oder besonders durch Alkyl substituiert sein können. Beispiele sind: Äthylendiamin, Propylendiamin, 1,3- oder 1,4-Butylendiamin, Pentylendiamin, 1,6-Hexylendiamin, Octylendiamin, Decylendiamin, Dodecylendiamin, 1,10-Alkyl substituierte 1,10-Decylendiamine wie z.B. 1,10-Dimethyl-1,10-decylendiamin oder 1,10-Di-n-Hexyl-1,10-decylendiamin, Xylylendiamin, Isophorondiamin, 1,3- oder 1,4-Cyclohexandiamin, 1,3- oder 1,4-Phenylendiamin, Methylphenylen-diamin, Toluylendiamin, p-Biphenylendiamin, Bis-(p-aminophenyl)äther, Bis-(p-aminophenyl)sulfon, Bis-(-p-aminophenyl)-methan.

Bei den Aminocarbonsäuren kann es sich um aromatische, cycloaliphatische oder aliphatische Aminocarbonsäuren handeln, z.B. Aminobenzoesäure, Aminocyclohexancarbonsäure und ω-Aminocarbonsäuren wie ε-Aminocapronsäure oder 11-Aminoundecansäure.

Eine weitere bevorzugte Gruppe an Polymeren für das erfindungsgemässe Material ist ein Polyester oder Copolyester aus organischen Diolen, Dicarbonsäuren, Hydroxycarbonsäuren und Diolen oder Dicarbonsäuren mit Strukturelementen der Formel I, worin q=1 ist und in denen an die R- und R′-Gruppen Hydroxyl oder Carboxylgruppen gebunden sind, sowie aus Mischungen der Monomeren.

Bei den Homopolyestern kann es sich um solche handeln, deren Molekülketten aus Diolen und Dicarbonsäuren der Formel III aufgebaut sind, oder um solche, deren Molekülketten aus Dicarbonsäuren oder Diolen der Formel III und organischen Diolen bzw. Dicarbonsäuren, die keine Benzophenonreste enthalten, aufgebaut sind. Die Copolyester enthalten weitere Reste von Dicarbonsäuren, Diolen und/oder Hydroxycarbonsäuren.

Geeignete Dicarbonsäuren wurden zuvor erwähnt. Polyester auf der Basis aromatischer Dicarbonsäuren, besonders Terephthalsäure und/oder Isophthalsäure sind bevorzugt. Als Diole kommen cycloaliphatische Diole wie 1,4-Cyclohexandiol, aromatische Diole wie Bisphenol-A und besonders gegebenenfalls substituierte aliphatische Diole wie verzweigte und besonders lineare Alkylendiole mit z.B. 2 bis 12, vorzugsweise 2 bis 6 C-Atomen sowie 1,4-Bis-hydroxymethylcyclohexan und Hydroxypivalinsäureneopentylglycolester in Frage. Besonders bevorzugt sind Äthylen-, Trimethylen-, Tetramethylen- und Hexamethylenglykol. Als Hydroxycarbonsäuren kommen z.B. m- oder p-Hydroxybenzoesäure oder aliphatische ω-Hydroxycarbonsäuren wie z.B. γ-Hydroxyvaleriansäure, Hydroxypivalinsäure sowie ε-Caprolacton in Frage.

In einer weiteren bevorzugten Ausführungsform sind die Polymeren für das erfindungsgemässe Material ein Polyamidimid oder ein Polyesterimid. Solche Polymeren sind durch den Einbau von Tricarbonsäuren der Formel IV oder deren polymerbildenden Derivaten, wie Ester, Anhydrid oder Säurehalogenid, erhältlich:

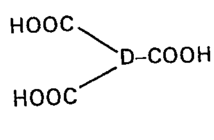

IV

Der dreiwertige Rest kann ein Kohlenwasserstoffrest mit bevorzugt 6 bis 16 C-Atomen sein, in dem zwei Carboxylgruppen an zwei benachbarte C-Atome gebunden ist. Bevorzugt ist Trimellitsäure.

Die Polyamidimide können nur aus Diaminen der Formel III und Tricarbonsäuren der Formel IV aufgebaut sein. Copolymere erhält man, wenn man zusätzlich Dicarbonsäuren und/oder Diamine, wie sie z.B. zuvor für die Polyamide erwähnt wurden, bei der Herstellung der Polyamidimide mitverwendet, auch solche der Formel III.

Polyesterimide sind erhältlich, wenn man zunächst eine Aminocarbonsäure bzw. einen Aminoalkohol mit Tricarbonsäuren der Formel IV zu Dicarbonsäuren bzw. Hydroxycarbonsäuren umsetzt, und diese darauf mit Diolen und/oder Dicarbonsäuren der Formel III weiter zu Polyestern polykondensiert. Auch hier können zusätzlich weitere Dicarbonsäuren und/oder Diole zur Herstellung von Copolymeren verwendet werden.

Ferner sind auch Polyesteramide bevorzugt. Diese Polymeren erhält man, wenn Dicarbonsäuren der Formel III und/oder weitere Dicarbonsäuren mit Diolen der Formel III und/oder anderen Diolen und Diaminen der Formel III und/oder anderen Diaminen polykondensiert werden, wobei die einzelnen Monomeren zuvor schon erwähnt wurden.

Die N-Atome der Amidgruppen in den zuvor genannten Polymeren können durch Alkyl mit vorzugsweise 1 bis 6 C-Atomen, Aryl wie z.B. Phenyl, Aralkyl wie z.B. Benzyl oder Cycloalkyl wie z.B. Cyclohexyl substituiert sein.

Weitere geeignete Polymere für das erfindungsgemässe beschichtete Material sind zum Beispiel:

a) Polysiloxane aus Diolen der Formel III und gegebenenfalls weiteren Diolen und Silanen der Formel $(R^{24})_2SiB_2$, worin $R^{24}$ bevorzugt Alkyl mit 1 bis 6 C-Atomen, besonders Methyl, Cycloalkyl, besonders Phenyl ist, und B, Br und besonders Cl oder Alkoxy sowie Aryloxy mit bevorzugt 1 bis 6 C-Atomen, besonders Methoxy oder Phenoxy steht. Diese Polymere können somit Strukturelemente der Formel

$$-\overset{R^{24}}{\underset{R^{24}}{Si}}-O-E-O-$$

und gegebenenfalls der Formel

$$-\overset{R^{24}}{\underset{R^{24}}{Si}}-O-E'-O$$

enthalten, worin E dem Rest der Formel I entspricht, worin q=1 ist, und E' der zweiwertige Rest eines Dioles ist. In Frage kommende Diole HOE'OH wurden schon zuvor erwähnt. Ferner können diese Polymeren zusätzliche Blöcke mit Strukturelementen der Formel

$$-\overset{R^{24}}{\underset{R^{24}}{Si}}O-$$

enthalten, wobei diese Blöcke bis zu 50 Mol.-% ausmachen können, bezogen auf das Polymer.

b) Ungesättigte Polyester aus ungesättigten Dicarbonsäuren, besonders Maleinsäure und Diolen der Formel I (HOEOH) und gegebenenfalls weiteren Dicarbonsäuren, auch der Formel I und weiteren Diolen HOE'OH. Geeignete Dicarbonsäuren wurden bereits zuvor erwähnt. Diese Polymeren können somit Strukturelemente der Formel

$$-\overset{O}{\overset{\|}{C}}-E''-\overset{O}{\overset{\|}{C}}-OEO-$$

enthalten, worin E'' der zweiwertige Rest einer äthylenisch ungesättigten Dicarbonsäure ist. Als weitere Strukturelemente können

$$-\overset{O}{\overset{\|}{C}}-E'''-\overset{O}{\overset{\|}{C}}-OEO-,\ -\overset{O}{\overset{\|}{C}}-E'''-\overset{O}{\overset{\|}{C}}-OE'O-\ \text{und}$$

$$-\overset{O}{\overset{\|}{C}}-E''-\overset{O}{\overset{\|}{C}}-OE'O,$$

enthalten sein, worin E''' der zweiwertige Rest einer Dicarbonsäure der Formel I oder einer anderen Dicarbonsäure ist.

Diese Polymeren können zusätzlich thermisch in Gegenwart üblicher Polymerisationskatalysatoren durch die Anwesenheit der äthylenisch ungesättigten Gruppen polymerisiert werden, gegebenenfalls zusammen mit reaktiven Verdünnern wie Styrol.

c) Geeignete Epoxidharze sind auf verschiedene Weise erhältlich. So können die Epoxidverbindungen der Formel III alleine oder zusammen mit weiteren Polyepoxidverbindungen mit mehr als einer Epoxidgruppe im Molekül katalytische z.B. mit tertiären Aminen zu Polyäthern umgesetzt werden oder sie können mit üblichen Härtern wie Polyolen, Polycarbonsäuren und deren Anhydriden oder Polyaminen reagiert werden. Als Härter können auch die Diamine, Diole und Dicarbonsäuren der Formel III verwendet werden, wobei dann auch nur übliche Polyepoxidverbindungen ohne Benzophenontetracarbonsäurereste verwendet werden können. Die Epoxidharze können als Präpolymere verwendet werden, die man nach der Bestrahlung thermisch aushärten kann.

d) Aromatische Polyäther sind z.B. durch die Umsetzung von Verbindungen der Formel III, worin Y=OH bzw. Halogen, besonders Br oder Cl ist, und R und R' ein aromatischer Rest bedeuten, mit phenylaromatischen Dichloriden oder Bromiden bzw. Diolen erhältlich. Geeignete Halogenide bzw. Diole sind z.B. ein- oder zweikernige phenylaromatische Derivate wie Hydrochinon, p-Dichlor- oder p-Dibromphenylen, p-Dihydroxyphenylen, p-Dichlor- oder p-Dibromdiphenylen, Bis(-p-Hydroxyphenyl)äther, Bis-(p-Chlorphenyl)äther.

Die phenylaromatischen Reste können weitere Substituenten enthalten, wie z.B. Alkyl mit bevorzugt 1 bis 4 C-Atomen enthalten. Verwendet man zweikernige phenylaromatische Reste, bei denen die Phenylgruppen an eine Sulfongruppe gebunden sind, so erhält man Polyäthersulfone. Beispiele für solche Derivate sind Bis(p-Chlorphenyl)-sulfon und Bis(p-hydroxyphenyl)sulfon. Polyäther, die nur Strukturelemente der Formel I enthalten, erhält man aus Verbindungen der Formel III, worin Y=OH ist, mit Verbindungen der Formel III, worin Y=Halogen ist.

e) Aromatische Polyketone sind erhältlich durch die Umsetzung von aromatischen Verbindungen der Formel III, worin Y=H ist, mit aromatischen Säurehalogeniden der Formel III, worin Y eine Säurehalogenidgruppe, besonders eine Säurechloridgruppe bedeutet, in Gegenwart von Lewis-Säuren. Zusätzlich können weitere aromatische, besonders phenylaromatische Verbindungen und/oder aromatische, besonders phenylaromatische Dicarbonsäuredihalogenide mitverwendet werden. Bei den aromatischen Verbindungen handelt es sich bevorzugt um ein- oder zweikernige Phenylaromaten bzw. um ihre Dicarbonsäuredihalogenidderivate. Beispiele sind Benzol, Toluol, Diphenyl, Diphenylmethan, Diphenylketon, Diphenylsulfon, Diphenyläther, Terephthalsäuredichlorid, 4,4'-Chlorcarbonyldiphenyl, -diphenylmethan, -diphenyläther oder -diphenylsulfon. Bei Verwendung der Ätherderivate erhält man Polyätherketone. Die aromatischen Kohlenwasserstoffe bzw. Dicarbonsäuredihalogenide können substituiert sein, z.B. mit Alkyl mit 1 bis 4 C-Atomen.

f) Aromatische Polythioäther sind z.B. erhältlich durch die Umsetzung von aromatischen Verbindungen der Formel III, worin Y=Halogen wie Cl und besonders Br ist, mit Dialkalisulfiden, z.B. $Na_2S$. Es können auch andere aromatische, besonders phenylaromatische Dihalogenverbindungen, bevorzugt Chloride und besonders Bromide mitverwendet werden. Aromatische Polysulfide sind auch erhältlich durch die Umsetzung von aromatischen Verbindungen der Formel III, worin Y=SH ist, alleine oder zusammen mit anderen besonders phenylaromatischen Dimerkaptanen, bzw. besonders deren Alkalisalzen wie z.B. der Natriumsalze, mit Verbindungen der Formel III, worin Y für Halogen, besonders Br steht, und/oder anderen besonders phenylaromatischen Dihalogeniden, wie z.B. Bromiden. Solche Halogenide wurden schon zuvor erwähnt. Geeignete aromatische Dimercaptane sind z.B. 1,4-Phenylendimerkaptan oder p-Biphenylendimerkaptan.

g) Weitere geeignete Polymere sind z.B. solche, die durch die Umsetzung von Verbindungen der Formel III, worin Y für OH, $NH_2$ oder COOH steht, mit Diisocyanaten oder Diepoxyden erhältlich sind.

h) Eine weitere Gruppe geeigneter Polymeren sind aromatische Polyimidazole. Sie sind erhältlich durch Umsetzung von Estern der Formel III alleine oder zusammen mit weiteren aromatischen Dicarbonsäurediestern und aromatischen Tetraminen, z.B. 3,3', 4,4'-Tetraaminobiphenyl, zu Polyamidvorstufen, die dann durch Erhitzen zu den Polyimidazolen kondensiert werden.

i) Eine weitere Gruppe geeigneter Polymere sind aromatische Polypyrrone. Sie sind z.B. erhältlich durch die Umsetzung von Tetracarbonsäureanhydriden der Formel V

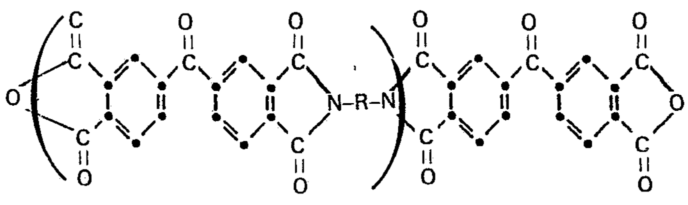

(V),

worin R die zuvor gegebene Bedeutung hat und d für eine Zahl von 1 bis 500 steht, mit aromatischen Tetraminen, wie z.B. 3,3', 4,4'-Tetraaminodiphenyl. Hierbei werden zunächst lösliche Vorstufen gebildet, die durch Erhitzen zu Polypyrronen polykondensiert werden. Die Verbindungen der Formel V sind erhältlich durch die Reaktion eines Überschusses von Benzophenontetracarbonsäuredianhydrid mit Diaminen der Formel $H_2NRNH_2$. Diese Verbindungen können z.B. auch zur Herstellung von Polyimiden verwendet werden.

Zur Herstellung des erfindungsgemässen beschichteten Materials oder des im erfindungsgemässen Verfahren einsetzbaren beschichteten Materials löst man das Polymer oder Gemische davon zweckmässig in einem geeigneten organischen Lösungsmittel, gegebenenfalls unter Erwärmung. Geeignete Lösungsmittel sind z.B. polare, aprotische Lösungsmittel, die alleine oder in Mischungen aus mindestens zwei Lösungsmitteln verwendet werden können. Beispiele sind: Äther wie Dibutyläther, Tetrahydrofuran, Dioxan, Methylenglykol, Dimethyläthylenglykol, Dimethyldiäthylenglykol, Diäthyldiäthylenglykol, Dimethyltriäthylenglykol, halogenierte Kohlenwasserstoffe wie Methylenchlorid, Chloroform, 1,2-Dichloräthan, 1,1,1-Trichloräthan, 1,1,2,2-Tetrachloräthan, Carbonsäureester und Lactone wie Essigsäureäthylester, Propionsäuremethylester, Benzoesäureäthylester, 2-Methoxyäthylacetat, γ-Butyrolacton, o-Valerolacten und Pivalolacton, Carbonsäureamide und Lactame wie Formamid, Acetamid, N-Methylformamid, N,N-Dimethylformamid, N,N-Diäthylformamid, N,N-Dimethylacetamid, N,N-Diäthylacetamid, γ-Butyrolactam, ε-Caprolactam, N-Methypyrrolidon, N-Acetylpyrrolidon, N-Methylcaprolactam, Tetramethylharnstoff, Hexamethylphosphorsäureamid, Sulfoxide wie Dimethylsulfoxid, Sulfone wie Dimethylsulfon, Diäthylsulfon, Trimethylensulfon, Tetramethylensulfon, Trimethylamin, Triäthylamin, N-Methylpyrrolidin, N-Methylpiperidin, N-Methylmorpholin, substituierte Benzole wie Chlorbenzol, Nitrobenzol, Phenole oder Kresol. Bei unlöslichen Polymeren kann man lösliche Vorstufen verwenden, die dann nach der Beschichtung bestrahlt und darauf durch Erhitzen in Polymere übergeführt werden.

Ungelöste Anteile können durch Filtration, bevorzugt einer Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung. Beschichtungsmittel mit Polymeren mit Strukturelementen der Formel I, worin R bzw. auch R' ein wie definiert substituierter aromatischer Rest oder araliphatischer Rest bedeuten, sind neu und ebenfalls ein Gegenstand der Erfindung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente und Haftvermittler. Ferner können auch, falls erwünscht, zusätzlich Sensibilitatoren, wie z.B. Thioxanthonderivate oder Benzophenonderivate einverleibt werden, um die Lichtempfindlichkeit noch weiter zu erhöhen, sowie Antihalofarbstoffe, wie sie z.B. in der US-A-4 349 619 beschrieben sind.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca. 500 μm und mehr, bevorzugt von 0,5 bis 500 μm und besonders von 1 bis 50 μm aufweisen.

Die strahlungsempfindliche Schicht im erfindungsgemässen Material kann durch Einwirkung von Strahlung vernetzt werden.

Die Photostrukturierung bzw. Photovernetzung kann durch energiereiche Strahlung hervorgerufen werden, z.B. durch Licht, insbesondere im UV-Bereich durch Röntgenstrahlen, Laserlicht, Elektronenstrahlen usw. Das erfindungsgemässe Material eignet sich hervorragend zur Herstellung von Schutzfilmen, Passivierlacken, und als photographisches Aufzeichnungsmaterial für thermostabile Reliefabbildungen.

Ein weiterer Gegenstand der Erfindung ist diese Verwendung. Anwendungsgebiete sind z.B. Schutz-, Isolier- und Passivierlacke in der Elektrotechnik und Elektronik, Photomasken für die Elektronik, den Textildruck und das graphische Gewerbe, Ätzresist zur Herstellung gedruckter Schaltungen und Druckplatten und integrierter Schaltkreise, Relais für die Herstellung von Röntgenmasken, als Löststopplack, als Delektrium für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten.

Die photographische Erzeugung der Reliefstruktur erfolgt durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung ist ein solches Verfahren zum Aufbringen von Reliefstrukturen. Als Entwickler sind z.B. die zuvor erwähnten Lösungsmittel geeignet.

Die Polymerschicht des erfindungsgemässen verwendbaren Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch hohe Haftfestigkeit und thermische, mechanische und chemische Widerstandsfähigkeit aus, insbesondere solche aus Polyimidschichten. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, ist aber vor Lichteinwirkung zu schützen.

Die nachfolgenden Beispiele erläutern die Erfindung näher.

A) Herstellung der Ausgangsprodukte

Beispiel 1

In einem zylindrischen Gefäss, das mit Rührer, Tropftrichter, Innenthermometer und Stickstoffeinleitungsrohr ausgestattet ist, werden unter Stickstoff 27,28 g (0,12 Mol) 4,4'-Diamino-3,3'-dimethyldiphenylmethan in 370 g N-Methylpyrrolidon (NMP) gelöst und auf 0 bis 5 °C abgekühlt. Nun werden 39,43 g (0,1225 Mol) Benzophenontetracarbonsäuredianhydrid (BTDA) bereitgestellt und in Portionen im Verlaufe von 4 Stunden zugesetzt. 30 Minuten nach dem letzten Zusatz werden 48,48 g Triäthylamin (0,48 Mol) und 110,1 g (1,08 Mol) Acetanhydrid zugetropft,

um die entstandene Polyamidsäure zum Polyimid zu cyclisieren. Nach 16 Stunden Rühren bei Raumtemperatur wird die Lösung unter starkem Rühren auf 6 l Wasser gegossen und das ausgefallene Produkt abfiltriert. Das Produkt wird erneut mit 6 l Wasser behandelt, filtriert und bei 80 °C im Vakuum getrocknet. Die inhärente Viskosität, gemessen als 0,5%-ige Lösung in NMP bei 25 °C beträgt 0,97 dl/g. Die Glasumwandlungstemperatur (Tg), gemessen durch Differential-Scanning-Calometrie (DSC) beträgt 285 °C.

Beispiel 2

Es wird wie in Beispiel 1 verfahren, aber ein Gemisch aus 66,7 Mol.-% BTDA und 33,3 Mol-% Pyromellitsäuredianhydrid (PMDA) eingesetzt. Eigenschaften des erhaltenen Copolyimides:

$\eta$ = 0,93 dl/g
Tg = 304 °C.

Beispiel 3

Gemäss Beispiel 1 wird ein technisches Gemisch von 3,3'-Diäthyl-4,4'-diaminodiphenylmethan, 3-Äthyl-4,4'-diaminodiphenylmethan und 4,4'-Diaminodiphenylmethan mit einer stöchiometrischen Menge BTDA umgesetzt und zum Polyimid cyclisiert.

$\eta$ = 1,00 dl/g
Tg = 263 °C.

Beispiel 4

Beispiel 3 wird wiederholt mit einem Gemisch aus 50 Mol-% BTDA und 50 Mol-% PMDA. Das erhaltene Copolyimid hat folgende Eigenschaften:

$\eta$ = 0,87 dl/g
Tg = 288 °C.

Beispiel 5

In einer Kondensationsapparatur wie in Beispiel 1 beschrieben, wird eine Lösung von 4,02 g Diamingemisch gemäss Beispiel 3 in NMP als Lösungsmittel mit 3,78 g BTDA (Molverhältnis Diamingemisch zu BTDA = 3:2) zu einem Polyamidsäureblock mit Aminoendgruppen kondensiert. Darauf wird die Lösung auf −15 °C abgekühlt und darauf zuerst 3,5717 g Isophthalsäuredichlorid und dann 2,6791 g Diamingemisch zugesetzt (Mol-Verhältnis Isophthalsäuredichlorid: Diamingemisch = 3:2). Durch Wegnehmen der Kühlung steigt die Temperatur allmählich auf Raumtemperatur. Nach 5 Stunden werden 3 ml Propylenoxyd und nach einer weiteren halben Stunde werden 6,51 g Triäthylamin und 26,6 g Acetanhydrid zugesetzt. Man lässt über Nacht rühren und fällt am nächsten Tag das Blockcopolyamidimid durch Einrühren in Wasser aus. Eigenschaften:

$\eta$ = 0,82 dl/g
Tg = 221 °C.

Beispiel 6

Gemäss Beispiel 1 wird eine Mischung von 4,4'-Diaminodiphenylmethan und 2,4-Diaminotoluol (Molverhältnis 19,7:80,3) mit der äquivalenten Menge BTDA polykondensiert. Eigenschaften des Polyimides:

$\eta$ = 0,43 dl/g
Tg = 309 °C.

Beispiel 7

Gemäss Beispiel 1 wird eine Mischung von 2,4-Diaminotoluol und 5,(6)-Amino-1-(4-aminophenyl)-1,3,3-trimethylindan (Mol-Verhältnis 54,4:45,6) mit einer äquivalenten Menge BTDA polykondensiert. Eigenschaften des Copolyimides:

$\eta$ = 0,42 dl/g
Tg = 309 °C.

Beispiele 8 und 9

Analog Beispiel 1 werden Polyimide durch Polykondensation von BTDA mit einer äquivalenten Menge 2-Amino-6-methyl-6-(4-aminophenyl)-heptan bzw. 2-Amino-6-methyl-6-(3-äthyl-4-aminophenyl)heptan hergestellt. Eigenschaften der Polyimide:

$\eta$ = 0,34 bzw. 0,23 dl/g
Tg = 177 °C bzw. 170 °C.

Beispiel 10

In einem Sulfierkolben mit Rührer, Innenthermometer, Stickstoffeinleitungsrohr und Wasserabscheider wird ein Gemisch von 13,21 g (0,038 Mol) 1,10-Diamino-1,10-di-n-hexyldecan und 13,34 g BTDA (0,038 Mol) in 100 ml o-Dichlorbenzol 30 min. lang unter Stickstoff gerührt. Dann wird das Gemisch langsam auf Rückflusstemperatur (175 °C) erhitzt, wobei eine klare hellgelbe Lösung entsteht. Im Verlaufe von 90 min. wird das Kondensationswasser zusammen mit o-Dichlorbenzol abdestilliert und im Wasserabscheider abgetrennt.

Eine Probe für analytische Zwecke wird isoliert, indem ein Teil der erkalteten Lösung in Hexan eingerührt wird, abfiltriert und getrocknet wird. Eigenschaften des Polyimides:

$\eta$ = 0,36 dl/g
Tg = 63 °C.

Beispiele 11–20

Gemäss Beispiel 1 werden nachfolgende Diamine mit BTDA zu Polyimiden polykondensiert und die angegebenen Eigenschaften der Polymeren ermittelt.

| Beispiel | Diamin | η (dl/g) | Tg ( °C) |
|---|---|---|---|
| 11 | 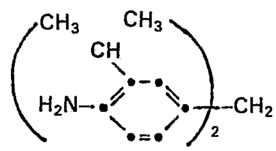 | 0,75 | 264 |
| 12 | 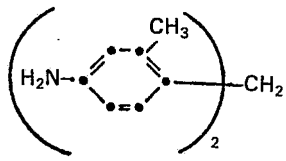 | 1,08 | 265 |
| 13 | 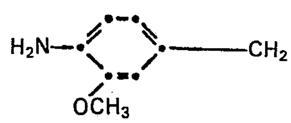 | 0,75 | 251 |
| 14 | 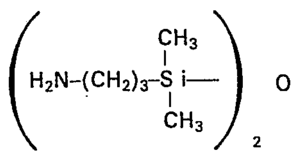 | 0,239 | 76 |
| 15 | 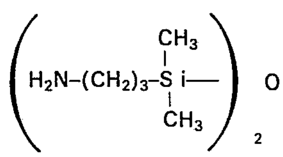 30 Mol% | 0,674 | 266 |
| | 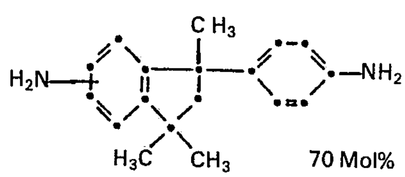 70 Mol% | | |
| 16 | 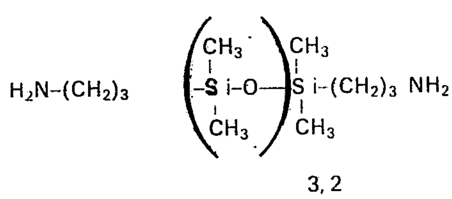 | 0,167 | 120 |
| 17 | 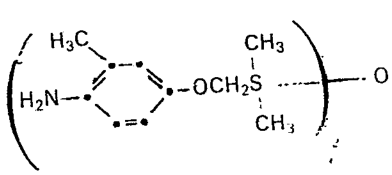 | 0,248 | 146 |

| | | | | |
|---|---|---|---|---|
| 18 | 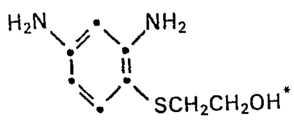 | 80 Mol% | 0,164 | 200 |
| | 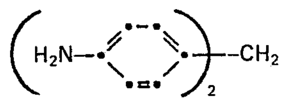 | 20 Mol% | | |
| 19 | 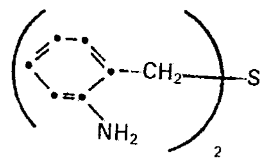 | | 0,376 | 204 |
| 20 | 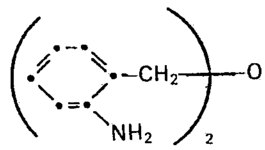 | | 0,115 | 197 |

*Umwandlung bei Cyclisierung mit Acetanhydrid in Essigsäureester

Beispiel 21

(Polyimid aus Isocyanat und Anhydrid)

In einem Reaktionsgefäss mit Rührer, Rückflusskühler und Gaseinleitung werden 0,7905 g (0,0021 Mol) N,N'-Di-(3-isocyanato-4-methyl)-phenylparabansäure, 1,4633 g (0,0084 Mol) Toluol-2,4-diisocyanat in DMSO (23 ml) bei Raumtemperatur unter $N_2$ vorgelegt und 3,386 g (0,0105 Mol) Benzophenontetracarbonsäuredianhydrid zugegeben. Die Mischung wird auf 90 °C erwärmt und 24 Stunden bei dieser Temperatur gehalten. Nach dem Abkühlen wird die Lösung in Wasser eingerührt und das Polymer ausgefällt.

$\eta$ = 0,228 dl/g.

Tg = 349 °C.

Beispiel 22

(Polyimid/Polyesteramid)

In einem Reaktionsgefäss werden 1,5 g (7,39 mMol) Isophthalsäuredichlorid in 38 ml N-Methylpyrrolidon (DMP) gelöst und auf −15 °C abgekühlt. Dann werden 0,537 g (4,92 mMol) m-Aminophenol und 1,4 ml Triäthylamin zugesetzt. Nach 30 Minuten werden 2,832 g (17,2 mMol) 3,6-Diaminodurol und 0,65 ml Triäthylamin zugesetzt. Durch Entfernung des Kühlbades lässt man die Temperatur auf 0 °C steigen und setzt 4,76 g (14,78 mMol) BTDA zu. Nach 8 Stunden Rühren bei Raumtemperatur wird die Polyamidsäure durch Zusatz von 4,5 ml Triäthylamin und 12,6 ml Acetanhydrid während 16 Stunden zum Polyimid cyclisiert und wie üblich aufgearbeitet.

$\eta$ = 0,38 dl/g

Beispiel 23

(Polyimid/Polycarbonat)

Unter den gleichen Bedingungen wie in Beispiel 26 werden folgende Komponenten in folgender Reihenfolge miteinander umgesetzt:

0,008 Mol Phosgen,

0,0053 Mol Bisphenol A,

0,01866 Mol Mesitylendiamin und

0,016 Mol BTDA.

$\eta$ = 0,16 dl/g

Tg = 261 °C.

Beispiel 24

(Polyimid/Polyamidimid)

7,5 mMol 4,4'-Diamino-3,5,3',5'-tetraäthyldiphenylmethan und 2,5 mMol 4,4'-Diaminodiphenylmethan werden in 25 ml NMP gelöst, die Lösung auf −15 °C abgekühlt und mit 2,5 mMol Trimellitsäureanhydridchlorid in Gegenwart von 0,4 ml Triäthylamin zur Reaktion gebracht. Das dabei entstandene Präpolymer wird dann mit 7,5 mMol BTDA weiter umgesetzt und anschliessend mit Triäthylamin und Acetanhydrid cyclisiert.
η = 0,58 dl/g
Tg = 257 °C.

Beispiel 25
(Polyimidester)
20 mMol 3-Amino-6-hydroxydurol werden in 34,5 ml NNP bei 0 °C mit 0,01 Mol BTDA umgesetzt. Anschliessend werden bei −15 °C 0,01 Mol Isophthalsäuredichlorid und 6,1 ml Triäthylamin zugesetzt. Nach 15 Minuten wird die Kühlung entfernt und bei Raumtemperatur noch 8 Stunden gerührt. Die Cyclisierung erfolgt mit Acetanhydrid
η = 0,09 dl/g
Tg = 127 °C.

Beispiel 26
(Polyimid/Polyphenylensulfid)
1,6458 g 3,6-Diaminodurol und 0,9333 g eines Polyphenylensulfides mit Aminoendgruppen [hergestellt nach Polymer Bulletin 4, 459–466 (1981)] werden in 24 ml NMP mit 3,4313 g BTDA bei 0 bis 25 °C während 24 Stunden umgesetzt und anschliessend mit Triäthylamin und Acetanhydrid cyclisiert.
η = 0,576 dl/g
Tg = 411 °C.

Beispiel 27
(Polyimid/Polyäthersulfon)
Das dazu verwendete Polyäthersulfon mit Aminoendgruppen wird durch Kondensation von 4,4'-Dichlordiphenylsulfon, Bisphenol A und 4-Chlornitrobenzol in Gegenwart von Kaliumcarbonat in DMF und anschliessende Reduktion der endständigen Nitrogruppen hergestellt. Analog Beispiel 26 werden 3,018 g 3,6-Diaminodurol und 1,796 g des Polyäthersulfons mit 6,231 g BTDA in 44 ml NMP umgesetzt und zum Polyimid cyclisiert.
η = 0,516 dl/g
Tg = 380 °C.

B) Anwendungsbeispiele
Auf einer einseitig Kupfer-kaschierten Kunststoffplatte wird ein dünner Polymerfilm erzeugt, indem eine 5%-ige Polymerlösung aufgeschleudert wird und das Lösungsmittel anschliessend in einem Umluftofen entfernt wird. Als Lösungsmittel werden Acetophenon (Polymere aus Beispiel 1, 2 und 4), Butyrolacton (Beispiel 3), o-Dichlorbenzol (Beispiel 10 ohne Isolierung des Polymeren) und N-Methylpyrrolidon bei den Polymeren der übrigen Beispiele verwendet.

Die so beschichteten Platten werden durch eine Photomaske (Stouffer-Keil) bei Raumtemperatur mit einer 1000 Watt-UV-Lampe aus 18 cm Entfernung belichtet. Die belichteten Platten werden anschliessend mit einem Lösungsmittel entwikkelt, wobei die unbelichteten Anteile des Polymerfilms weggelöst werden. Die Sichtbarmachung des Reliefbildes geschieht anschliessend durch Wegätzen der freigelegten Kupferschicht mit $FeCl_3$-Lösung.

Die Belichtungszeit, der verwendete Entwickler und die Lichtempfindlichkeit sind in nachfolgender Tabelle angegeben. MEK ist Methyläthylketon, DMF ist Dimethylformamid.

Tabelle

| Polymer gemäss Beispiel | Belichtungszeit (Sekunden) | Entwickler | Empfindlichkeit (Stouffer-Skala) |
|---|---|---|---|
| 1 | 120 | NMP | 6–7 |
| 2 | 120 | NMP | 5 |
| 3 | 100 | NMP | 5 |
| 4 | 240 | NMP | 4–5 |
| 5 | 300 | NMP | 8 |
| 6 | 360 | NMP | 6 |
| 7 | 360 | NMP | 3 |
| 8 | 120 | NMP/MEK (1:1) | 6 |
| 9 | 120 | NMP/MEK (1:1) | 9 |
| 10 | 15 | NMP | 7 |
| 11 | 5 | DMF | 5 |
| 12 | 600 | NMP | 4–5 |
| 13 | 300 | DMF | 5–6 |
| 14 | 180 | NMP | 4 |
| 15 | 500 | Xylol/$CHCl_3$ (1:2) | 4 |
| 16 | 120 | NMP | 3 |
| 17 | 600 | Toluol/$CHCl_3$ (9:1) | 1 |
| 18 | 900 | NMP | 1 |
| 19 | 240 | NMP | 6 |
| 20 | 600 | Toluol/NMP (3:10) | 1 |

Tabelle *(Fortsetzung)*

| Polymer gemäss Beispiel | Belichtungszeit (Sekunden) | Entwickler | Empfindlichkeit (Stouffer-Skala) |
|---|---|---|---|
| 21 | 600 | NMP | 3 |
| 22 | 300 | $CHCl_3$ | 7–8 |
| 23 | 360 | NMP | 3 |
| 24 | 300 | NMP | 9 |
| 25 | 300 | NMP | 3–4 |
| 26 | 240 | NMP | 5–6 |
| 27 | 120 | NMP | 7 |

**Patentansprüche**

1. Verfahren zur Herstellung einer Reliefstruktur oder einer Schutzschicht auf einem Träger, auf den ein strahlungsempfindliches Homo- oder Copolymer als Schicht aufgebracht ist, wobei besagtes Homo- oder Copolymer mindestens 5 Mol.-%, bezogen auf das Polymer, Struktureinheiten der Formel I enthält

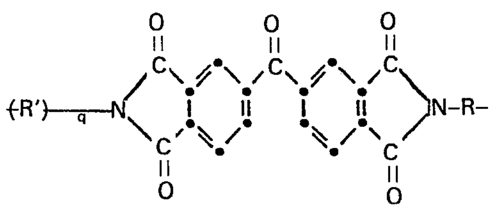
(I),

worin R ein unsubstituierter oder substituierter zweiwertiger aliphatischer Rest, der durch Heteroatome, aromatische, heterocyclische oder cycloaliphatische Gruppen unterbrochen sein kann, ein unsubstituierter oder substituierter cycloaliphatischer oder araliphatischer Rest, ein aromatischer Rest, bei dem zwei Arylkerne über eine aliphatische Gruppe verknüpft sind, oder ein durch mindestens eine Alkylgruppe, Cycloalkylgruppe, Alkoxygruppe, Alkoxyalkylgruppe, Alkylthiogruppe, Alkylthioalkylgruppe, Hydroxyalkylgruppe, Hydroxyalkoxygruppe, Hydroxyalkylthiogruppe, Aralkylgruppe oder zwei benachbarte C-Atome des aromatischen Restes durch eine Alkylengruppe substituierter aromatischer Rest ist, R' unabhängig die gleiche Bedeutung wie R hat und q für 0 oder 1 steht, wobei R als aromatischer Rest nicht durch Alkylen und nicht in beiden Orthostellungen zum N-Atom durch die zuvor genannten Reste substituiert ist, wenn q=0 ist, umfassend die Schritte

i) bildmässiges oder direktes Belichten mit energiereicher Strahlung und gegebenenfalls

ii) Entfernen der unbelichteten Anteile mit einem Entwickler.

2. Verfahren gemäss Anspruch 1, dadurch gekennzeichnet, dass das Homo- oder Copolymer 5 bis 100 Mol.-% Struktureinheiten der Formel I enthält, bezogen auf das Polymer.

3. Verfahren gemäss Anspruch 1, dadurch gekennzeichnet, dass der Substituent am aromatischen Rest 1 bis 20 C-Atome enthält.

4. Verfahren gemäss Anspruch 3, dadurch gekennzeichnet, dass der Substituent Alkyl, Alkoxy oder Alkoxyalkyl mit 1 bis 6 C-Atomen, Benzyl oder Trimethylen oder Tetramethylen ist.

5. Verfahren gemäss Anspruch 1, dadurch gekennzeichnet, dass ein oder zwei Substituenten im aromatischen Rest in Orthostellung zum N-Atom gebunden sind.

6. Verfahren gemäss Anspruch 1, dadurch gekennzeichnet, dass R als aliphatischer Rest 2 bis 30 C-Atome, als cycloaliphatischer Rest 5 bis 8 Ring-C-Atome, als araliphatischer Rest 7 bis 30 C-Atome und als substituierter aromatischer Rest 7 bis 30 C-Atome enthält.

7. Verfahren gemäss Anspruch 1, dadurch gekennzeichnet, dass R als aliphatischer Rest lineares oder verzweigtes Alkylen ist, das durch Sauerstoffatome, NH, $NR^a$ oder $^{\oplus}NR^a_2G^{\ominus}$, worin $R^a$ Alkyl mit 1 bis 12 C-Atomen oder Cycloalkyl mit 5 oder 6 Ring-C-Atomen, Phenyl oder Benzyl ist und $G^{\ominus}$ das Anion einer Protonensäure ist, Cyclohexylen, Naphthylen, Phenylen oder Hydantoine unterbrochen sein kann, R als cycloaliphatischer Rest unsubstituiertes oder durch Alkyl substituiertes mono- oder bicyclisches Cycloalkylen mit 5 bis 7 Ring-C-Atomen, R als araliphatischer Rest unsubstituiertes oder am Aryl durch Alkyl substituiertes Aralkylen ist, wobei der Alkylenrest linear oder verzweigt sein kann, und R als aromatischer Rest ein Kohlenwasserstoffrest oder Pyridinrest ist, der durch Alkyl, Alkoxy, Alkoxyalkyl, Trimethylen, Tetramethylen substituiert ist.

8. Verfahren gemäss Anspruch 7, dadurch gekennzeichnet, dass R als aliphatischer Rest lineares oder verzweigtes Alkylen mit 6 bis 30 C-Atomen, $-(CH_2)_m-R^1-(CH_2)_n-$, worin $R^1$ Phenylen, Naphthylen, Cyclopentylen oder Cyclohexylen und m und n unabhängig voneinander eine Zahl von 1, 2 oder 3 sind, $-R^2-(OR^3)_p-O-R^2-$, worin $R^2$ Äthylen, 1,2-Propylen, 1,3-Propylen oder 2-Methyl-1,3-propylen und $R^3$ Äthylen, 1,2-Propylen, 1,2-Butylen, 1,3-Propylen oder 1,4-Butylen und p eine Zahl von 1 bis 100 sind, oder

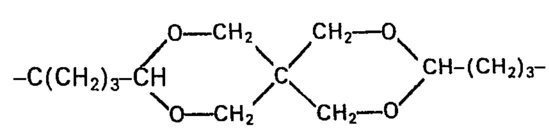

ist.

9. Verfahren gemäss Anspruch 7, dadurch gekennzeichnet, dass R als cycloaliphatischer Rest solche Formeln

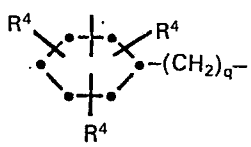 oder 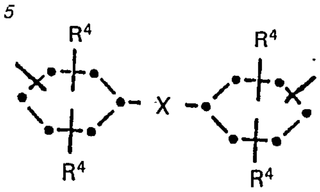

sind, worin q 0 oder 1 ist, $R^4$ unabhängig Wasserstoff oder Alkyl mit 1 bis 6 C-Atomen bedeutet, und X für eine direkte Bindung, O, S, Alkylen mit 1 bis 3 C-Atomen oder Alkyliden mit 2 bis 6 C-Atomen steht.

10. Verfahren gemäss Anspruch 7, dadurch gekennzeichnet, dass der araliphatische Rest der Formel

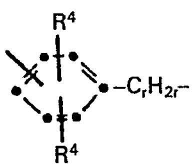

entspricht, worin die $R^4$ unabhängig ein Wasserstoffatom oder Alkyl mit 1 bis 6 C-Atomen und r ganze Zahlen von 1 bis 16 bedeuten.

11. Verfahren gemäss Anspruch 7, dadurch gekennzeichnet, dass der aromatische Rest den Formeln

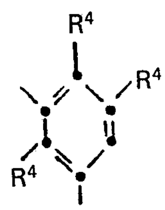 , 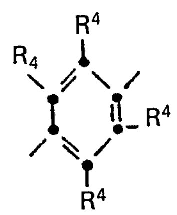 , 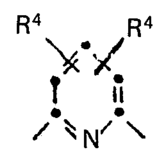 ,

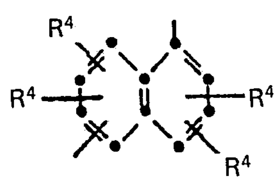 , 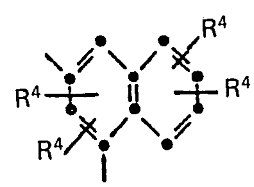 , 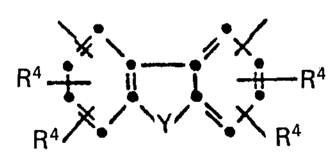

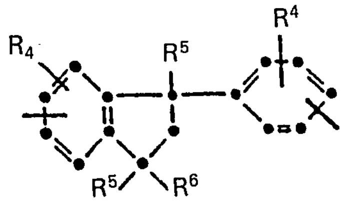 oder

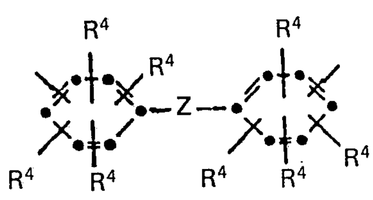 ,

entspricht, worin $R^4$ im Falle der Monosubstitution Alkyl mit 1 bis 6 C-Atomen und die anderen $R^4$ Wasserstoff sind, und im Falle der Di-, Tri- oder Tetrasubstitution zwei $R^4$ Alkyl mit 1 bis 6 C-Atomen und die anderen $R^4$ ein Wasserstoffatom oder Alkyl mit 1 bis 6 C-Atomen sind oder im Falle der Di-, Tri- oder Tetrasubstitution zwei vicinale $R^4$ im Phenylring für Trimethylen oder Tetramethylen und die anderen $R^4$ für ein Wasserstoffatom oder Alkyl mit 1 bis 6 C-Atomen stehen, Y für O, S, NH, CO oder $CH_2$ steht, $R^5$ ein Wasserstoffatom oder Alkyl mit 1 bis 5 C-Atomen und $R^6$ Alkyl mit 1 bis 5 C-Atomen darstellt, und Z eine direkte Bindung, O, S, SO, $SO_2$, CO, $\overset{O}{\overset{\|}{C}}$O, $\overset{O}{\overset{\|}{C}}$ $NR^7$, $NR^7$, CONH, NH, $R^7SiR^8$, $R^7OSiOR^8$,

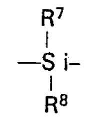 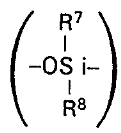

Alkylen mit 1 bis 6 C-Atomen, Alkenylen oder Alkyliden

mit 2 bis 6 C-Atomen, Phenylen oder Phenyldioxyl bedeutet, worin $R^7$ und $R^8$ unabhängig voneinander Alkyl mit 1 bis 6 C-Atomen oder Phenyl bedeuten und j für 1–10 steht.

12. Verfahren gemäss Anspruch 11, dadurch gekennzeichnet, dass der aromatische Rest

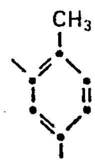 , 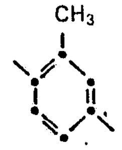 , 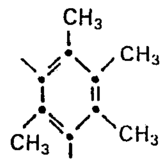 , 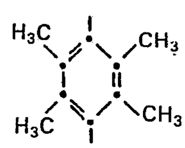

oder 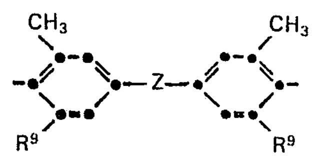

ist, worin Z eine direkte Bindung, O und besonders $CH_2$ bedeutet und $R^9$ ein Wasserstoffatom, Methyl oder Äthyl darstellt.

13. Verfahren gemäss Anspruch 1, dadurch gekennzeichnet, dass das Homo- oder Copolymer ausgewählt ist aus der Gruppe der Polyimide, Polyamide, gesättigte Polyester, Polycarbonate, Polyamidimide, Polyesterimide, Polyesteramide, Polysiloxane, ungesättigten Polyestern, Epoxidharze, der aromatischen Polyäther, der aromatischen Polyätherketone, der aromatischen Polyäthersulfone, der aromatischen Polyketone, der aromatischen Polythioäther, der aromatischen Polyimidazole, der aromatischen Polypyrrone oder Gemischen dieser Polymeren.

14. Verfahren gemäss Anspruch 13, dadurch gekennzeichnet, dass das Polymer ein Polyimid mit wiederkehrenden Strukturelementen der Formel I ist, wobei q=0 ist, oder ein Copolyimid aus wiederkehrenden Strukturelementen der Formel I, worin q=0 ist, und wiederkehrenden Strukturelementen der Formel II

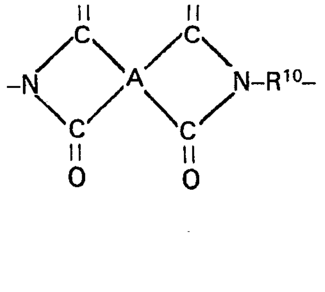 (II)

worin A ein vierwertiger organischer Rest und $R^{10}$ ein zweiwertiger organischer Rest sind.

15. Verfahren zur Herstellung einer Reliefstruktur gemäss Anspruch 1 umfassend zusätzlich als Schritt iii) eine thermische Nachbehandlung mit der das erzeugte Bild stabilisiert wird.

16. Verwendung des nach dem Verfahren gemäss Anspruch 1 erhältlichen photovernetzten Materials als Schutzfilm, Passivierlack oder als photographisches Aufzeichnungsmaterial für thermostabile Reliefabbildungen.

17. Beschichtetes Material aus einem Träger, auf dem ein strahlungsempfindliches Homo- oder Copolymer aufgebracht ist, dadurch gekennzeichnet, dass besagtes Homo- oder Copolymer wenigstens 5 Mol.-%, bezogen auf das Polymer, an Struktureinheiten der Formel I gemäss Anspruch 1 enthält, worin q 1 ist, und dass besagtes Homo- oder Copolymer ausgewählt ist aus der Gruppe der Polyamide, gesättigten Polyestern, Polycarbonate, Polyamidimide, Polyesterimide, Polyesteramide, Polysiloxane, ungesättigten Polyestern, Epoxidharze, der aromatischen Polyäther, der aromatischen Polyätherketone, der aromatischen Polyäthersulfone, der aromatischen Polyketone, der aromatischen Polythioäther, der aromatischen Polyimidazole, der aromatischen Polypyrrone oder Gemischen dieser Polymeren.

18. Material gemäss Anspruch 17, dadurch gekennzeichnet, dass R und R' aromatische Reste der Formeln

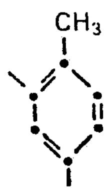, 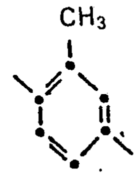, 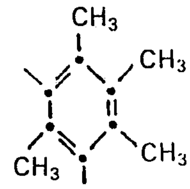, 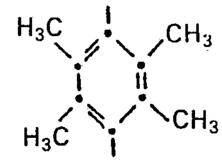

oder 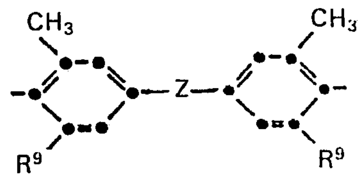

sind, worin Z eine direkte Bindung, O und besonders $CH_2$ bedeutet und $R^9$ ein Wasserstoffatom, Methyl oder Äthyl darstellt.

19. Material gemäss Anspruch 17, dadurch gekennzeichnet, dass das Polymer ein Polyamid oder Copolyamid aus organischen Diaminen, Dicarbonsäuren, ω-Aminocarbonsäuren und Diaminen oder Dicarbonsäuren mit Strukturelementen der Formeln I, worin q=1 ist und in denen an die R- und R'-Gruppen Amingruppen oder Carboxylgruppen gebunden sind, ist, sowie aus Mischungen der Monomeren.

20. Material gemäss Anspruch 17, dadurch gekennzeichnet, dass das Polymer ein Polyester oder Copolyester aus organischen Diolen, Dicarbonsäuren, Hydroxycarbonsäuren und Diolen oder Dicarbonsäuren mit Strukturelementen der Formel I, worin q=1 ist und in denen an die R- und R'-Gruppen Hydroxyl oder Carboxylgruppen gebunden sind, ist, sowie aus Mischungen der Monomeren.

**Revendications**

1. Procédé pour créer une structure en relief ou une couche protectrice sur un support sur lequel un homopolymère ou copolymère sensible au rayonnement est déposé sous la forme d'une couche, ledit homopolymère ou copolymère renfermant au moins 5% en moles, par rapport au polymère, de motifs répondant à la formule I:

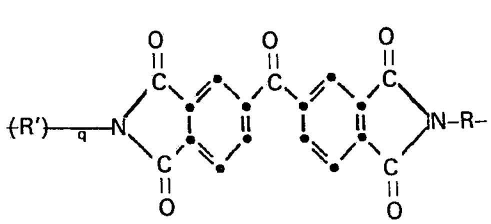

(I)

dans laquelle R représente un radical aliphatique bivalent, substitué ou non, qui peut être interrompu par des hétéroatomes ou par des radicaux aromatiques, hétérocycliques ou cycloaliphatiques, un radical cycloaliphatiques ou araliphatique, substitué ou non, un radical aromatique dans lequel deux noyaux aryles sont reliés par un radical aliphatique, ou un radical aromatique qui porte au moins un substituant pris dans l'ensemble constitué par les radicaux alkyles, cycloalkyles, alcoxy, alcoxyalkyles, alkylthio, alkylthioalkyles, hydroxyalkyles, hydroxyalcoxy, hydroxyalkylthio et aralkyles ou dont deux atomes de carbone voisins portent un radical alkylène, R' a l'une des significations qui viennent d'être données pour R mais indépendamment de celui-ci, et q est égal à 0 ou à 1, avec la condition que, dans le cas où q est égal à 0, le radical R, s'il est un radical aromatique, ne porte pas de radical alkylène ou ne porte aucun des substituants mentionnés ci-dessus en ortho par rapport à l'atome d'azote, procédé qui comprend les étapes suivantes:

(i) on expose à un rayonnement de haute énergie directement ou conformément à une image et, éventuellement:

(ii) on élimine au moyen d'un développateur les parties qui n'ont pas été touchées par le rayonnement.

2. Procédé selon la revendication 1 caractérisé en ce que l'homopolymère ou le copolymère contient de 5 à 100% en moles de motifs de formule I, par rapport au polymère.

3. Procédé selon la revendication 1 caractérisé en ce que le substituant porté par le radical aromatique contient de 1 à 20 atomes de carbone.

4. Procédé selon la revendication 3 caractérisé en ce que le substituant est un radical alkyle, alcoxy ou alcoxyalkyle contenant de 1 à 6 atomes de carbone, un radical benzyle ou un radical triméthylène ou tétraméthylène.

5. Procédé selon la revendication 1 caractérisé en ce qu'un ou deux substituants, sur le radical aromatique, sont en ortho par rapport à l'atome d'azote.

6. Procédé selon la revendication 1 caractérisé en ce que R, en tant que radical aliphatique, contient de 2 à 30 atomes de carbone, en tant que radical cycloaliphatique contient de 5 à 8 atomes de carbone dans son cycle, en tant que radical araliphatique contient de 7 à 30 atomes de carbone, et en tant que radical aromatique substitué contient de 7 à 30 atomes de carbone.

7. Procédé selon la revendication 1 caractérisé en ce que R représente:

– en tant que radical aliphatique, un alkylène linéaire ou ramifié qui peut être interrompu par des atomes d'oxygène, par des radicaux NH,NR$^a$ ou $^{\oplus}NR^a{}_2G^{\ominus}$ (où R$^a$ désigne un alkyle en $C_1$–$C_{12}$, un cycloalkyle dont le cycle contient 5 ou 6 atomes de carbone, un phényle ou un benzyle et $G^{\ominus}$ représente l'anion d'un acide protonique), ou par un radical cyclohexylène, naphtylène ou phénylène, ou encore par un radical d'hydantoïne,

–en tant que radical cycloaliphatique, un cycloalkylène mono- ou bicyclique contenant de 5 à 7 atomes de carbone dans le cycle, non substitué ou porteur d'un alkyle,

– en tant que radical araliphatique, un aralkylène qui ne porte pas de substituant ou dont la partie aryle porte un alkyle et dont la partie alkylène peut être linaire ou ramifiée, et

– en tant que radical aromatique, un radical hydrocarboné ou un radical de pyridine, qui porte un radical alkyle, alcoxy, alcoxyalkyle, triméthylène ou tétraméthylène.

8. Procédé selon la revendication 7 caractérisé en ce que R, en tant que radical aliphatique, est un alkylène linéaire ou ramifié qui contient de 6 à 30 atomes de carbone, ou est un radical $-(CH_2)_m-R^1-(CH_2)_n-$ dans lequel R$^1$ représente un radical phénylène, naphtylène, cyclopentylène ou cyclohexylène tandis que m et n représentent chacun, indépendamment l'un de l'autre, un nombre égal à 1, à 2 ou à 3, ou est un radical $-R^2(OR^3)_pO-R^2-$ dans lequel R$^2$ représente un radical éthylène, propylène-1,2, propylène-1,3 ou méthyl-2 propylène-1,3, R$^3$ représente un radical éthylène, propylène-1,2, butylène-1,2, propylène-1,3 ou butylène-1,4 et p désigne un nombre de 1 à 100, ou représente le radical:

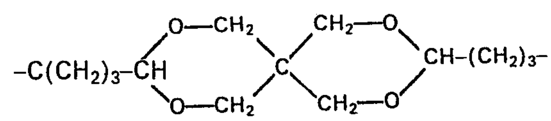

9. Procédé selon la revendication 7 caractérisé en ce que R, en tant que radical cycloaliphatique, répond à l'une des formules suivantes:

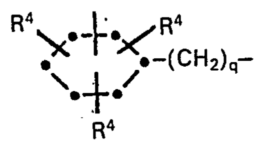

et

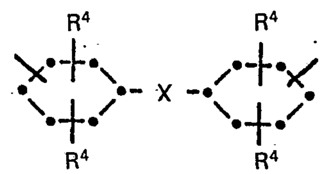

dans lesquelles q est égal à 0 ou à 1, les R$^4$ représentent chacun, indépendamment les uns des autres, l'hydrogène ou un alkyle contenant de 1 à 6 atomes de carbone, et X représente une liaison directe, O, S, un alkylène en $C_1$–$C_3$ ou un alkylidène en $C_2$–$C_6$.

10. Procédé selon la revendication 7 caractérisé en ce que le radical araliphatique répond à la formule suivante:

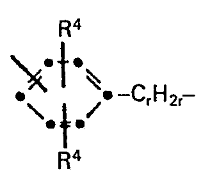

dans laquelle les R$^4$ représentent chacun, indépendamment l'un de l'autre, un atome d'hydrogène ou un alkyle en $C_1$–$C_6$, et r désigne un nombre entier de 1 à 16.

11. Procédé selon la revendication 7 caractérisé en ce que le radical aromatique répond à l'une des formules suivantes:

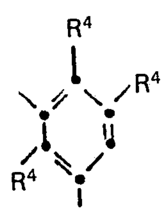

,

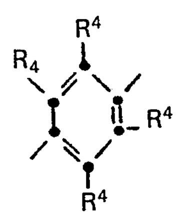

,

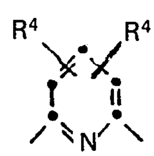

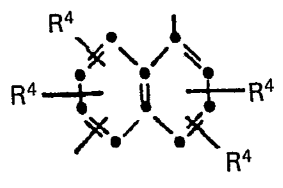

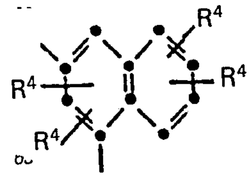

,

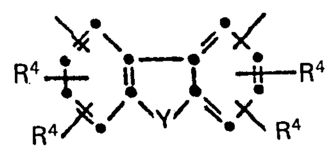

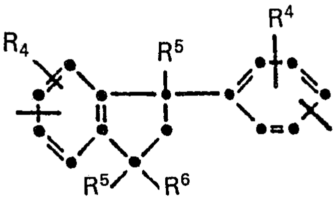 et

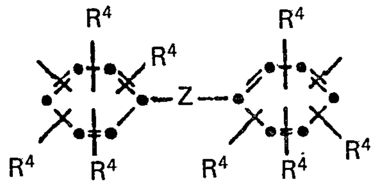,

dans lesquelles $R^4$, dans le cas de la monosubstitution, représente un alkyle contenant de 1 à 6 atomes de carbone et les autres $R^4$ représentent chacun l'hydrogène, et, dans le cas de la di-, tri- ou tétrasubstitution, deux $R^4$ représentent chacun un alkyle en $C_1$–$C_6$ et les autres $R^4$ chacun un atome d'hydrogène ou un alkyle en $C_1$–$C_6$, ou, dans le cas de la di-, tri- ou tétrasubstitution, deux $R^4$ voisins sur le noyau phényle représentent un radical triméthylène ou tétraméthylène et les autres $R^4$ représentent chacun un atome d'hydrogène ou un alkyle en $C_1$–$C_6$, Y représente O, S, NH, CO ou $CH_2$, $R^5$ représente un atome d'hydrogène ou un alkyle contenant de 1 à 5 atomes de carbone, $R^6$ représente un alkyle contenant de 1 à 5 atomes de carbone, et Z représente une liaison directe, O, S, SO, $SO_2$, CO, $\overset{\overset{O}{\|}}{C}O$, $\overset{\overset{O}{\|}}{C}NR^7$, $NR^7$, CONH, NH, $R^7SiR^8$, $R^7OSiOR^8$,

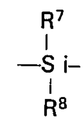 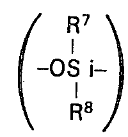

un alkylène contenant de 1 à 6 atomes de carbone, un alcénylène en $C_2$–$C_6$, un alkylidène en $C_2$–$C_6$, un phénylène ou un phényl-dioxy, $R^7$ et $R^8$ représentent chacun, indépendamment l'un de l'autre, un alkyle en $C_1$–$C_6$ ou un phényle et j représente un nombre de 1 à 10.

12. Procédé selon la revendication 11 caractérisé en ce que le radical aromatique répond à l'une des formules suivantes:

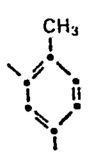, 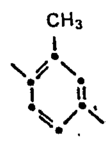, 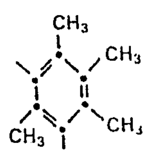, 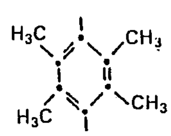

ou à la formule:

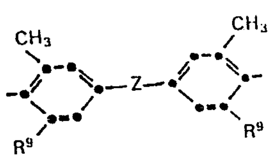

dans laquelle Z représente une liaison directe, O ou, mieux, $CH_2$, et $R^9$ représente un atome d'hydrogène ou un radical méthyle ou éthyle.

13. Procédé selon la revendication 1 caractérisé en ce que l'homopolymère ou le copolymère est choisi dans l'ensemble constitué par les polyimides, les polyamides, les polyesters saturés, les polycarbonates, les polyamide-imides, les polyester-imides, les polyesteramides, les polysiloxanes, les polyesters insaturés, les résines époxydiques, les polyéthers aromatiques, les polyéther-cétones aromatiques, les polyéther-sulfones aromatiques, les polycétones aromatiques, les polythioéthers aromatiques, les polyimidazoles aromatiques, les polypyrrones aromatiques et les mélanges de ces polymères.

14. Procédé selon la revendication 13, caractérisé en ce que le polymère est un polyimide renfermant des éléments structuraux répétés de formule I dans lesquels q est égal à 0, ou un copolyimide constitué d'éléments structuraux répétés de formule I dans lesquels q est égal à 0 et d'éléments structuraux répétés qui répondent à la formule II:

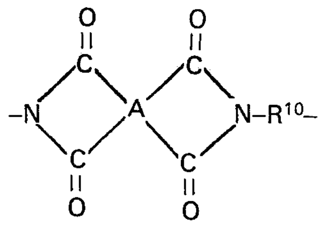 (II)

dans laquelle A représente un radical organique quadrivalent et $R^{10}$ un radical organique bivalent.

15. Procédé pour créer une structure en relief selon la revendication 1 qui comprend en outre, comme étape iii), un traitement complémentaire par la chaleur par lequel l'image produite est stabilisée.

16. Application de la matière photoréticulée qui peut être obtenue par le procédé de la revendication 1 comme pellicule protectrice, comme vernis passivant ou pour la réalisation d'images en relief stables à la chaleur.

17. Matière revêtue constituée d'un support sur lequel est déposé un homopolymère ou un copolymère sensible au rayonnement, matière caractérisée en ce que ledit homopolymère ou copolymère contient au moins 5% en moles, par rapport au polymère, de motifs de formule I selon le revendication 1 dans lesquels q est égal à 1, et en ce que ledit homopolymère ou copolymère est choisi dans l'ensemble constitué par les polyamides, les polyesters saturés, les polycarbonates, les polyamide-imides, les poly-ester-imides, les polyesters-amides, les polysiloxanes, les polyesters insaturés, les résines époxydiques, les polyéthers aromatiques, les poly-éthers-cétones aromatiques, les poly-éther-sulfones aromatiques, les polycétones aromatiques, les poly-thio-éthers aromatiques, les polyimidazoles aromatiques, les polypyrrones aromatiques et les mélanges de ces polymères.

18. Matière selon la revendication 17 caractérisée en ce que R et R' représentent chacun un radical aromatique répondant à l'une des formules suivantes:

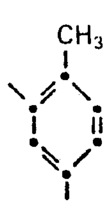 , 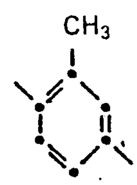 , 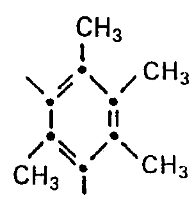 , 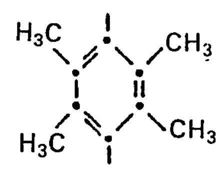

et 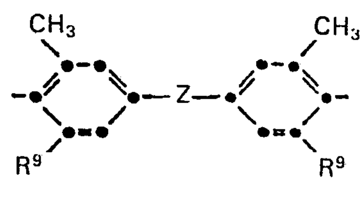

(dans cette dernière Z représente une liaison directe, O ou, mieux, $CH_2$) et $R^9$ représente un atome d'hydrogène, un radical méthyle ou un radical éthyle.

19. Matière selon la revendication 7, caractérisée en ce que le polymère est un polyamide ou un copolyamide dérivant de diamines organiques, d'acides dicarboxyliques, d'acides ω-aminocarboxyliques, et de diamines ou d'acides dicarboxyliques qui renferment des éléments structuraux de formule I dans lesquels q est égal à 1 et dans lesquels des radicaux amino ou des radicaux carboxy sont liés aux radicaux R et R', ainsi que de mélanges des monomères.

20. Matière selon la revendication 7, caractérisée en ce que le polymère est un polyester ou un copolyester dérivant de diols organiques, d'acides dicarboxyliques, d'acides hydrocarboxyliques, et de diols ou d'acides dicarboxyliques qui renferment des éléments structuraux de formule I dans lesquels q est égal à 1 et dans lesquels des radicaux hydroxy ou carboxy sont liés aux radicaux R et R', ou de mélanges des monomères.

**Claims**

1. A process for the preparation of a relief structure or protective film on a support to which a radication-sensitive homopolymer or copolymer is applied as film, which homopolymer or copolymer contains at least 5 mol-%, based on the polymer, of structural units of formula I

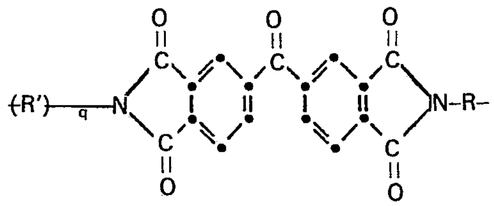 (I)

wherein R is an unsubstituted or substituted divalent aliphatic radical which can be interrupted by heteroatoms or aromatic, heterocyclic or cycloaliphatic groups, an unsubstituted or substituted cycloaliphatic or araliphatic radical, an aromatic radical in which two aryl nuclei are linked through an aliphatic group, or is an aromatic radical which is substituted by at least one alkyl, cycloalkyl, alkoxy, alkoxyalkyl, alkylthio, alkylthioalkyl, hydroxyalkyl, hydroxyalkoxy, hydroxyalkylthio or aralkyl group, or in which two adjacent carbon atoms of the aromatic radical are substituted by an alkylene group, R' independently has the same meaning as R and q is 0 or 1, with the proviso that an aromatic radical R is not substituted by alkylene and is not substituted by the abovementioned radicals in both positions ortho to the N atom if q is 0, comprising the steps of

i) exposing the polymer film imagewise or direct to high-energy radiation, and

ii) removing any unexposed areas of the polymer film with a developer.

2. A process according to claim 1, wherein the homopolymer or copolymer contains 5 to 100 mol-% of structural units of formula I, based on the polymer.

3. A process according to claim 1, wherein the substituent on the aromatic radical contains 1 to 20 carbon atoms.

4. A process according to claim 3, wherein the substituent is alkyl, alkoxy or alkoxyalkyl of 1 to 6 carbon atoms, benzyl, trimethylene or tetramethylene.

5. A process according to claim 1, wherein one or two substituents on the aromatic radical are bonded in the ortho-position relative to the N atom.

6. A process according to claim 1, wherein an aliphatic radical R contains 2 to 30 carbon atoms, a cycloaliphatic radical R contains 5 to 8 ring carbon atoms, an araliphatic radical R contains 7 to 30 carbon atoms, or a substituted aromatic radical R contains 7 to 30 carbon atoms.

7. A process according to claim 1, wherein an aliphatic radical R is linear or branched alkylene which can be interrupted by oxygen atoms, NH, $NR^a$ or $^{\oplus}NR^a{}_2G^{\ominus}$, in which $R^a$ is alkyl of 1 to 12 carbon atoms, cycloalkyl containing 5 or 6 ring carbon atoms, phenyl or benzyl, and $G^{\ominus}$ is the anion of a protic acid, or by cyclohexylene, naphthylene, phenylene or hydantoins; a cycloaliphatic radical R is monocyclic or bicyclic cycloalkylene which contains 5 to 7 ring carbon atoms and is unsubstituted or substituted by alkyl; an araliphatic radical R is aralkylene which is unsubstituted or substituted on the aryl by alkyl, which alkylene radical may be linear or branched; or an aromatic radical R is a hydrocarbon or pyridine radical which is substituted by alkyl, alkoxy, alkoxyalkyl, trimethylene or tetramethylene.

8. A process according to claim 7, wherein an aliphatic radical R is linear or branched alkylene of 6 to 30 carbon atoms, $-(CH_2)_m-R^1-(CH_2)_n-$, in which $R^1$ is phenylene, naphthylene, cyclopentylene or cyclohexylene, and m and n are each independently of the other 1, 2 or 3, or is $-R^2-(OR^3)_p-O-R^2-$, in which $R^2$ is ethylene, 1,2-propylene, 1,3-propylene or 2-methyl-1,3-propylene, $R^3$ is ethylene, 1,2-propylene, 1,2-btuylene, 1,3-propylene or 1,4-butylene and p is an integer from 1 to 100, or is

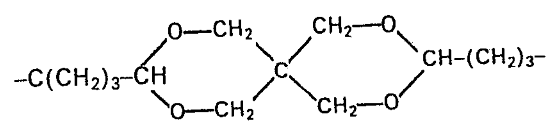

9. A process according to claim 7, wherein a cycloaliphatic radical R is a radical of formula

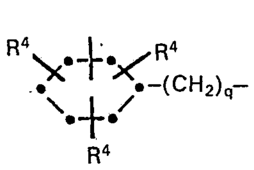 or 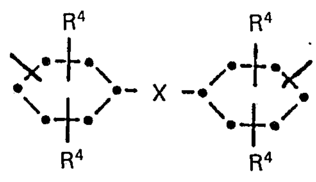

in which q is 0 or 1, each $R^4$ is independently hydrogen or alkyl of 1 to 6 carbon atoms and X is a direct bond, O, S, alkylene of 1 to 3 carbon atoms or alkylidene of 2 to 6 carbon atoms.

10. A process according to claim 7, wherein the araliphatic radical has the formula

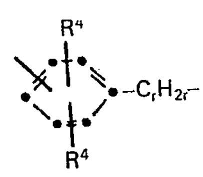

in which each $R^4$ independently of the other is a hydrogen atom or alkyl of 1 to 6 carbon atoms and r is an integer from 1 to 16.

11. A process according to claim 7, wherein the aromatic radical has the formula

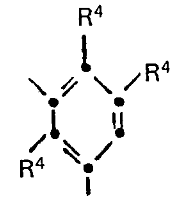

,

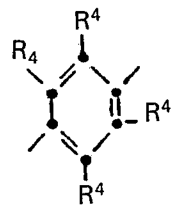

,

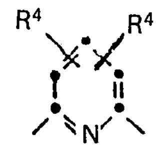

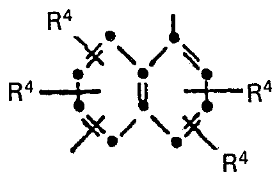

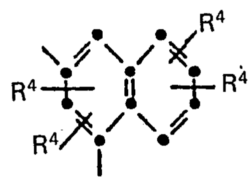

,

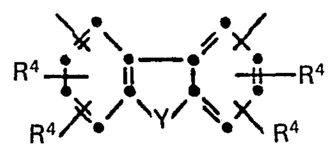

,

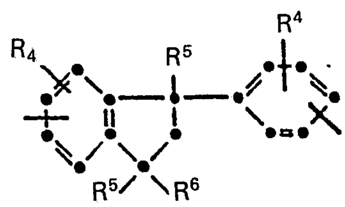

or

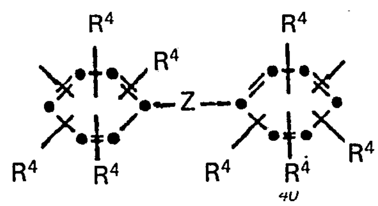

,

in which, if one substituent is present, one of $R^4$ is alkyl of 1 to 6 carbon atoms and the others are hydrogen and, if two, three or four substituents are present, two of $R^4$ are alkyl of 1 to 6 carbon atoms and the others are hydrogen atoms or alkyl of 1 to 6 carbon atoms, or, if two, three or four substituents are present, two of $R^4$ adjacent in the phenyl ring are trimethylene or tetramethylene and the others are hydrogen atoms or alkyl of 1 to 6 carbon atoms, Y is O, S, NH, CO or $CH_2$, $R^5$ is a hydrogen atom or alkyl of 1 to 5 carbon atoms, $R^6$ is alkyl of 1 to 5 carbon atoms and Z is a direct bond, O, S, SO, $SO_2$, $\overset{\text{O}}{\overset{\|}{\text{C}}}\text{O}$, $\overset{\text{O}}{\overset{\|}{\text{C}}}\text{O}$, $CNR^7$, $NR^7$, CONH, NH, $R^7SiR^8$, $R^7OSiOR^8$,

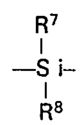

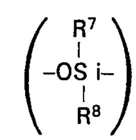

alkylene of 1 to 6 carbon atoms, alkenylene or alkylidene of 2 to 6 carbon atoms, phenylene or phenyldioxy, in which $R^7$ and $R^8$ are each independently of the other alkyl of 1 to 6 carbon atoms or phenyl and j is 1–10.

12. A process according to claim 11, wherein the aromatic radical is

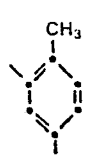

,

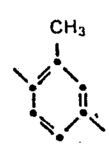

,

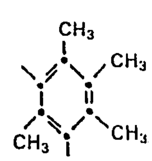

,

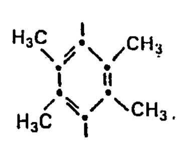

.

or 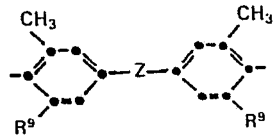

in which Z is a direct bond, O or, in particular, $CH_2$ and $R^9$ is a hydrogen atom, methyl or ethyl.

13. A process according to claim 1, wherein the homopolymer or copolymer is selected from the group comprising the polyimides, polyamides, saturated polyesters, polycarbonates, polyamide imides, polyester imides, polyester amides, polysiloxanes, unsaturated polyesters, epoxy resins, aromatic polyethers, aromatic polyether ketones, aromatic polyether sulfones, aromatic polyketones, aromatic polyimide azoles, aromatic polypyrrones, aromatic polythioethers, or mixtures of said polymers.

14. A process according to claim 13, wherein the polymer is a polyimide containing recurring structural units of formula I in which q is 0, or a copolyimide of recurring structural units of formula I in which q is 0, and recurring structural units of formula II

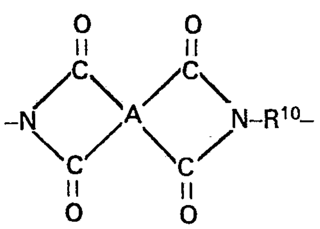 (II)

wherein A is a tetravalent organic radical and $R^{10}$ is a divalent organic radical.

15. A process for the preparation of a relief structure as claimed in claim 1, comprising the additional step iii) of a thermal aftertreatment for stabilising the image produced.

16. Use of the photocrosslinkable material obtainable according to claim 1 as protective film, insulating lacquer or heat-stable relief image.

17. A coated material comprising a support to which a radiationsensitive homopolymer or copolymer is applied, wherein said homopolymer or copolymer contains at least 5 mol-%, based on the polymer, of structural units of formula I according to claim 1, and is selected from the group comprising the polyimides, saturated polyesters, polycarbonates, polyamide imides, polyester imides, polyester amides, polysiloxanes, unsaturated polyesters, epoxy resins, aromatic polyethers, aromatic polyether ketones, aromatic polyether sulfones, aromatic polyketones, aromatic polythioethers, aromatic polyimide azoles, aromatic polypyrrones, or mixtures of said polymers.

18. A material according to claim 17, wherein R and R' are aromatic radicals of formula

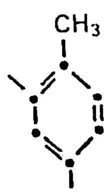 , 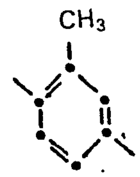 , 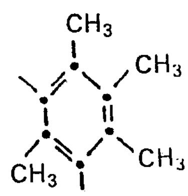 , 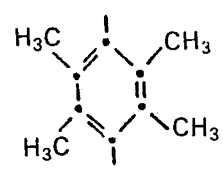

or 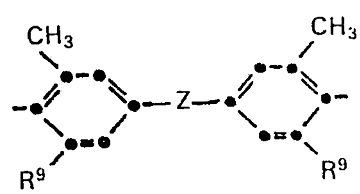

wherein Z is a direct bond, O and, in particular, $CH_2$ and $R^9$ is a hydrogen atom, methyl or ethyl.

19. A material according to claim 17, wherein the polymer is a polyamide or copolyamide of organic diamines, dicarboxylic acids, ω-aminocarboxylic acids and diamines or dicarboxylic acids containing structural units of formula I in which q is 1 and in which amino groups or carboxyl groups are attached to the R and R' groups, and mixtures of the monomers.

20. A material according to claim 17, wherein the polymer is a polyester or copolyester of organic diols, dicarboxylic acids, hydroxycarboxylic acids and diols or dicarboxylic acids containing structural units of formula I in which q is 1 and in which hydroxyl or carboxyl groups are attached to the R and R' groups, and mixtures of the monomers.